(19) **Europäisches Patentamt**

**European Patent Office**

**Office européen des brevets**

(11) **EP 1 526 641 A1**

(12) **EUROPEAN PATENT APPLICATION**

(43) Date of publication:
**27.04.2005 Bulletin 2005/17**

(51) Int Cl.[7]: **H03H 17/02**

(21) Application number: **03292632.1**

(22) Date of filing: **22.10.2003**

(84) Designated Contracting States:
**AT BE BG CH CY CZ DE DK EE ES FI FR GB GR
HU IE IT LI LU MC NL PT RO SE SI SK TR**
Designated Extension States:
**AL LT LV MK**

(71) Applicant: **ALCATEL
75008 Paris (FR)**

(72) Inventor: **Jaenecke, Peter, Dr.
75334 Straubenhardt (DE)**

(74) Representative: **Rausch, Gabriele, Dr. et al
Alcatel
Intellectual Property Department, Stuttgart
70430 Stuttgart (DE)**

(54) **A method for determining a filter, a filter, and a telecommunication device**

(57) The invention relates to a method for determining a filter comprising the steps of determining a set of filter requirements and a set of signal constraints, determining a suited filter transfer function by choosing a set of suited transfer functions and determining a set of parameters of the set of suited transfer functions, and combining said set of transfer functions to a suited filter transfer function, where said set of suited transfer functions is determined by solving a variational problem that is equivalent to the set of filter requirements and a set of signal constraints. The invention further relates to a filter implementation and a telecommunication device.

Figure 9

**Description**

The present invention relates to a method for determining and realizing a filter, the filter itself and a telecommunication device.

Any medium through which a signal passes, whatever its form, is regarded as a filter, when it can modify a signal in some way.

A digital filter is a filter that operates on digital signals, represented inside e.g. a computer or signal processor. It can be realized, specified, and characterized by a computation (transformation) which takes one sequence of numbers, the input signal, and produces a new sequence of numbers, the (filtered) output signal. Filters as mentioned in the previous paragraph need not to be digital only because they operate on signals that might be continuous.

A digitally implemented filter can do anything that a real-world filter can do. That is, all the filters can be simulated to an arbitrary degree of precision digitally.

A filter is not only a formula for going from one digital signal to another. It may exist as an equation on paper, as a small loop in a computer routine, as a handful of integrated circuit chips properly interconnected, or as passive elements like capacities or inductivities.

A signal, more precisely of a real discrete-time signal, is modeled by a real-valued function of the integers. Similarly a complex discrete-time signal is modeled by a complex-valued function of the integers.

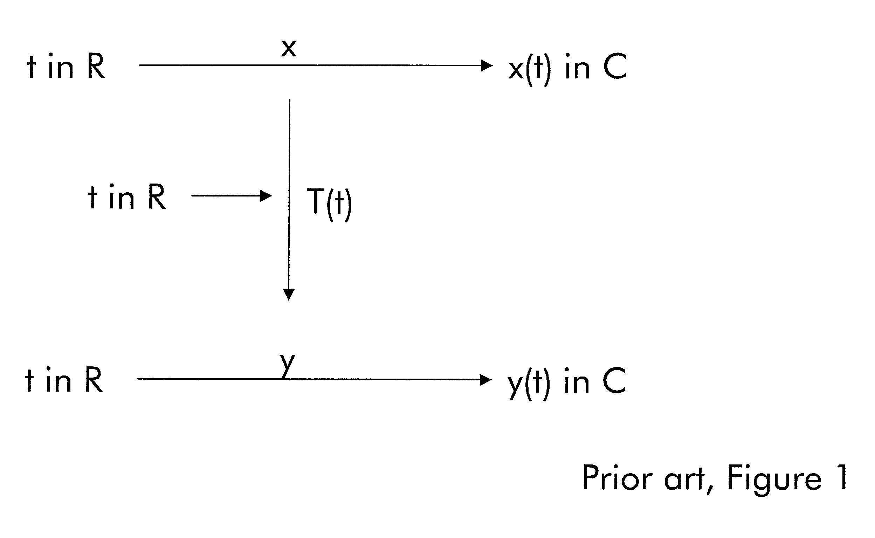

Using the usual set notation Z, R, and C to denote the set of all integers, real numbers, and complex numbers, respectively, one can express a real, discrete-time signal by a function mapping every integer n to a real number $x(n)$. Similarly, a discrete-time complex signal is a mapping u from each integer n to a complex number $u(n)$ i.e., a complex number for every integer, as shown e.g. in figure 1.

Sometimes these notations are slightly expanded to include functions of the form $x(nt)$, $u(nt)$ denoting a sampling interval "t". The time index has physical units of seconds, but it is isomorphic to the integers. For finite-duration signals, one could prepend and append zeros to extend its domain to all integers.

Mathematically, the set of all signals can be regarded as a vector space in which every signal is a vector. The n-th sample is regarded as the n-th vector coordinate. Since the signal models are infinitely long (being defined over all integers), the corresponding vector space is infinite-dimensional. Every vector space comes with a field of scalars which we may think of as constant gain factors that can be applied to any signal in the space.

By definition, a vector space is closed under linear combinations. A linear combination is a mix of two signals using mixing gains. Thus, a signal mix is represented mathematically as a linear combination of vectors.

The definition of a filter, more precisely of a digital filter is any real or complex valued function of a signal for each integer.

We may express the input-output relation of a digital filter by a functional, i.e. by the notation $y(n) = T(n)(x(n))$, where $x(n)$ denotes the input signal, and $y(n)$ is the output signal at time "n". The general filter is denoted by "T". The filter is an operator on the space of signals. The operator maps every signal to some new signal, as illustrated in figure 1. Figure 2 shows the corresponding commuting diagram in a continuous time domain and figure 3 shows the commuting diagram to the above described input-output relation of a digital filter.

This invention is illustrated by concerning primarily single-input, single-output digital filters for the sake of simplicity, although the theory and the realization of the invention generalizes straight forward using functions and operators in multiple variables. For this reason, the input and output signals of a digital filter are defined as real or complex scalars for each time index (as opposed to vectors). When both the input and output signals are vector-valued, multi-input, multi-output digital filters resulting.

There are several (time-domain) representations for digital filters, including the difference equation, system diagram, and impulse response. Additionally, the convolution representation for filters is described.

The difference equation is a formula for computing an output sample based on past and present input samples and past output samples in the time domain. The general difference equation is:

$$y(n) = b0\ x(n) + b1\ x(n-1) + ... + bM\ x(n-M) +$$

$$a1\ x(n+1) + ... + aN\ x(n+N)$$

where "x" is the input signal, "y" is the output signal, and the constants "b0", "b1", ..., "bM", "a1", "a2", ..., "aN" are called coefficients.

Each such equation correspond naturally to a system diagram in signal processing, e.g. realized by a circuitry comprising delay elements, resistors, and amplifiers etc. or by a program for a signal processor.

In addition to difference-equation coefficients, a filter may be represented in the time domain by its response to a specific impulse signal. This response is called the impulse response of the filter. Any filter is specified by convoluting the input signal with the filter impulse response.

Let the impulse signal be denoted by d and defined by d(0) = 1 and d(x) = 0 otherwise. The impulse response h(n) of a filter is the response of the filter T is h(n) = T(n)(d(n)). The impulse response h(n) is the response of the filter at time "n" to a unit impulse occurring at time "0".

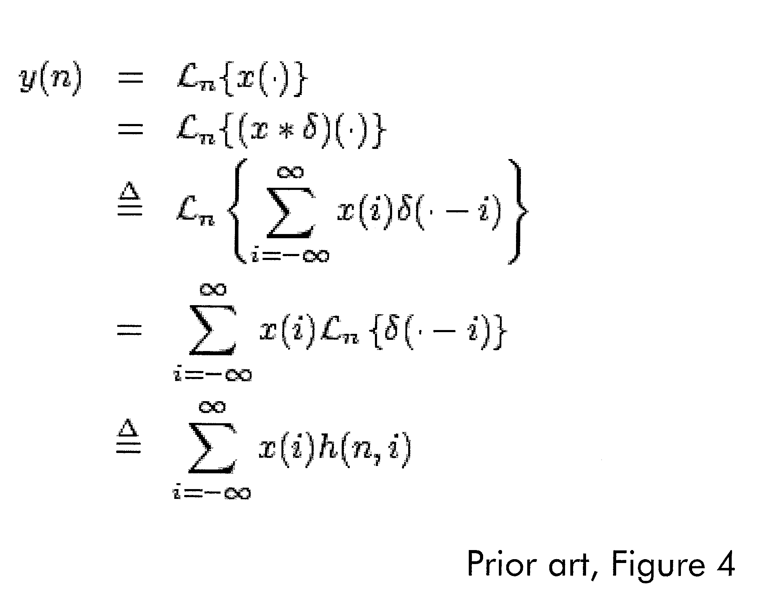

In figure 4 the convolution formula is derived. The first step is to express an arbitrary signal as a linear combination of shifted impulses, i.e.,

$$x(n) \quad \doteq x(0)\, d(n) + x(1)d(n\text{-}1) + x(2)d(n\text{-}2) + \ldots + \; x(n\text{-}1)^*d(1) + x(n)d(0)$$
$$= (x * d)(n)$$

where "*" denotes the convolution operator.

The above equation is built up intuitively. Imagine d has a "1" in the midst of an infinite string of "0's". Now think of d(n-i) as the same pattern shifted over "i" to the right by samples. Next multiply by x(i), which plucks out the sample x(i) and surrounds it on both sides by "0's". Now, sum over all factors, bringing together all the samples x(n) of one at a time "n", to obtain "x". Thus, any signal may be expressed as a weighted sum of shifted impulses.

The equation expresses a signal as a linear combination (or weighted sum) of impulses. That is, each sample may be viewed as an impulse at some amplitude and time. Each impulse (sample) arriving at the filter's input will cause the filter to produce an impulse response. If another impulse arrives at the filter's input before the first impulse response has died away, then the impulse response for both impulses will superimpose (add together sample by sample). More generally, since the input is a linear combination of impulses, the output is the same linear combination of impulse responses.

Figure 4 shows this in more precise terms, where h(n, i) denotes the filter response at time n to an impulse which occurred at time "i".

In natural words: the filter output is defined by the convolution of the input with the filter impulse response function. The infinite case can be handled by practical limits. By choosing e.g. time "0" as the beginning of the signal, one may define to be "0" for so that the lower summation limit of can be replaced by "0".

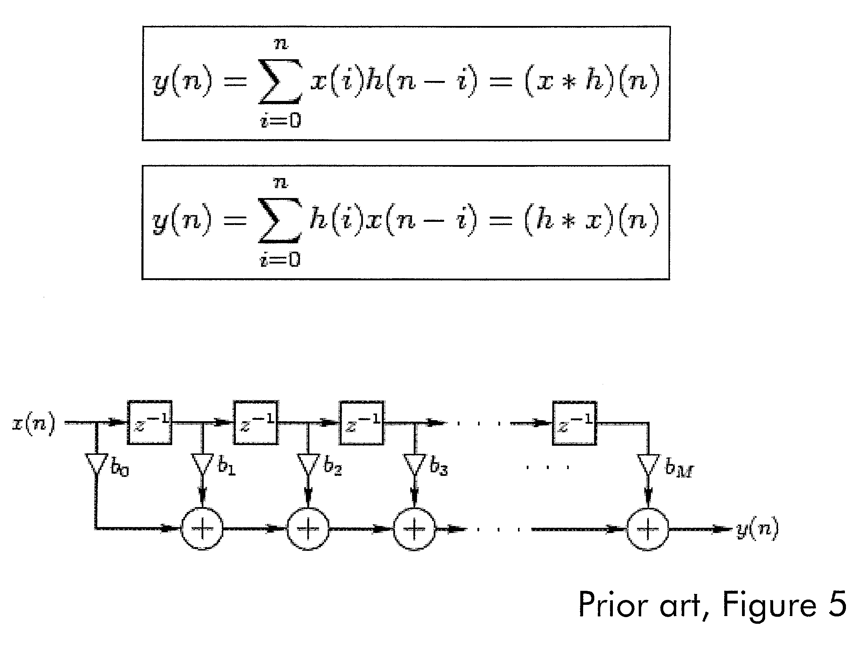

This gets us down to the ultimate convolution representation of a special case, the linear, time-invariant, causal digital filter, shown in figure 5. This filter is further considered in order to avoid unnecessary complex mathematical presentations. It is noted that the application of the method according to the invention is not limited to that case. This is only done for the sake of illustration.

This filter presentation shown in figure 5 looks more like a difference equation. In this form one can see that may be identified with the coefficients. It is also evident that the filter operates by summing weighted echoes of the input signal together.

Obviously the output of an filter may be calculated by convolving the input with the impulse response. It is instructive to compare this method of filter implementation to the use of difference equations. If there is no feedback, then the difference equation and the convolution formula are identical. For recursive filters, one can convert the difference equation into a convolution by calculating the filter impulse response. However, this can be rather tedious, since with nonzero feedback coefficients the impulse response generally remains forever. Of course, for stable filters the response is infinite only in theory; in practice, one may simply truncate the response after an appropriate length of time, e.g. such as after it falls below the noise' level due to round-off error.

Figure 5 gives in addition a system diagram of a filter. It is also called a transversal filter, or a tapped delay line. The implementation is one example of a direct form implementation of a digital filter.

The transfer function provides an algebraic representation of a linear, time-invariant filter in the frequency domain. These systems are usually
characterized by a frequency-domain description known as the transfer function (or system function).

The transfer function of a linear time-invariant discrete-time filter might be defined as X(z)/Y(z), where a capital letter denotes the z-transform of a function denoted by the corresponding lower case.

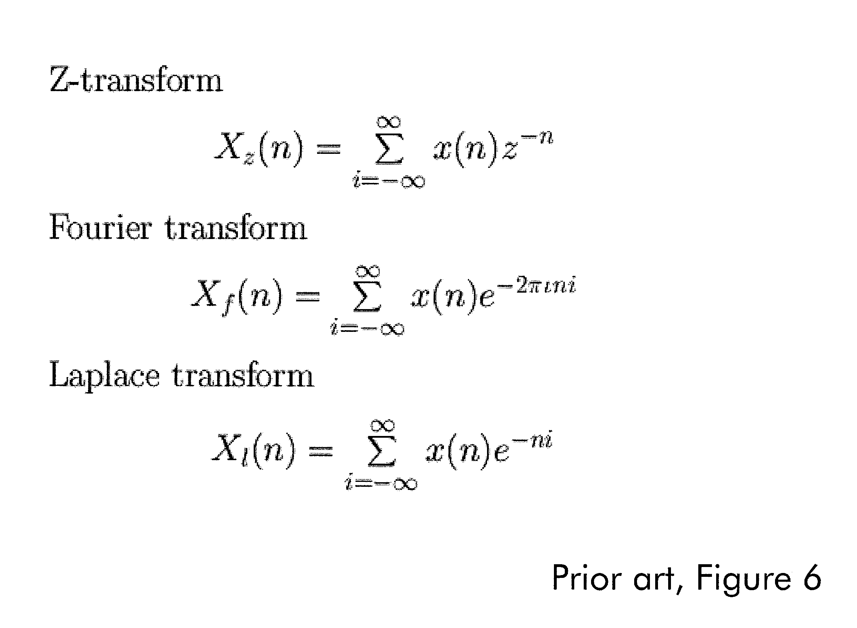

The z transformation along with other transforms is shown in figure 6. It turns out that the transfer function is the z transform of the filter impulse response.

The connections between the various filter presentations could for instance be found in the introduction part of the forthcoming textbook of Julius O. Smith III, Introduction to Digital Filters.

It is well known that similar other transformations could be used to map signals from the time domain into a frequency domain, e.g. a Fourier transform or a Laplacae transform. This fact results from the convolution property that is shared among these transformations, namely convolution in the time domain is multiplication in the frequency domain. A further property is that each of these transforms has its inverse.

It should be further noted that the continuos considerations of the above stated filter presentations work as well, i.e. there exist similar theories where e.g. the sums are replaced by integrals over certain intervals etc.

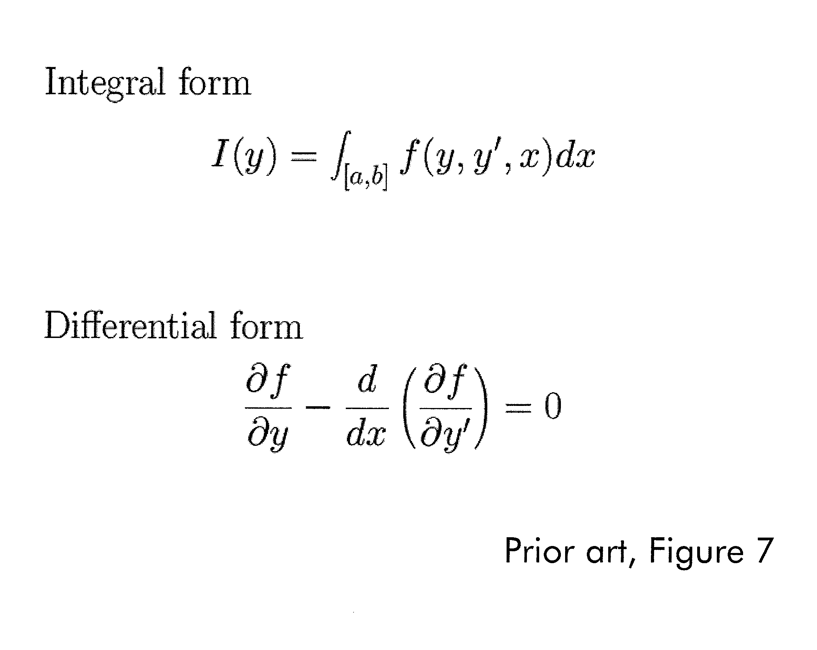

A branch of mathematics which is a sort of generalization of calculus is the calculus of variations. Calculus of variations seeks to find a path, curve, surface, etc., for which a given function has a stationary value (which, in physical problems, is usually a minimum or maximum). Mathematically, in it's simplest form this involves finding stationary values of integrals of the form shown in figure 7. It has an extremum only if the Euler-Lagrange differential equation is satisfied, also shown in figure 7.

The calculus of variations is generalized to higher dimensions, higher deviates, multiple functions, parameterized functions, functions with constraints etc. see e.g. in the corresponding chapter of the textbook Handbuch der Mathematik of llja N. Bronstein et al. These generalizations are here avoided for the sake of simplicity. A generalization of calculus of variations known as Morse theory and sometimes called "calculus of variations in the large" uses nonlinear techniques to address variational problems. Furthermore there are a bunch of well known techniques for defining constraints on the solutions.

Usually there is no closed presentation of the solution function(s) of a variational problem. But in these cases numerical analysis for solving the variational problem is applicable, e.g. the Ritz-method, which could be found in the textbook Handbuch der Mathematik, too.

A method of influencing an input signal, wherein said input signal has a range of input amplitudes, wherein a output signal depending on said input signal is generated, and wherein said input signal is influenced depending on said output signal is well known from signal processing, e.g. a distorter.

The generation of said output signal is based on a plurality of base functions that are combined. These base functions comprise usually parameters and the final parameterized base function is usually determined by using approximation techniques (usually in the time domain).

Signals are means for information interchange, e.g. modulation of encoded information.

This method of parametrizing and combining base functions in order to provide a filter is limited with respect to signal constraints.

It is a known problem providing a suitable filter when this filter has to fulfill heavy constraints on the signal, e. g. orthogonality conditions or limited band leakage.

The usual (practical) solution is to create filters according to prior art and test the behavior, e.g. via a simulation, whether the filter fulfils its requirements.

The invention provides a different approach to solve this problem. The problem is solved by a method for providing a filter comprising the steps of

- determining a set of filter requirements and a set of signal constraints,

- determining a suited filter transfer function by choosing a set of suited transfer functions and determining a set of parameters of the set of suited transfer functions, and combining said set of transfer functions to a suited filter transfer function,

- realizing the filter specified by the determined suited filter transfer function

   where said set of suited transfer functions is determined by solving a variational problem that is equivalent to the set of filter requirements and a set of signal constraints.

The problem is solved, inter alia, by a filter compliant with a set of filter requirements and a set of signal constraints, where the filter is defined by a set of filter transfer functions that is determined by solving a variational problem that is equivalent to the set of filter requirements and a set of signal constraints.

And the problem is solved by a telecommunication device comprising filter for transforming an input signal into an output signal according to a set of filter requirements and a set of signal constraints, where the filter is defined by a set of filter transfer functions that is determined by solving a variational problem that is equivalent to the set of filter requirements and a set of signal constraints.

Accordingly, it is advantage of the present invention to provide an extension to the set of filters, allowing to identify e.g. arbitrary filter transfer functions and not only the composition of a family of parameterized basic transfer functions.

Another advantage of the present invention is that it provides filters with an improved performance. E.g. it allows soft-clipping with power level differences less than 20 db. Up to the inventors knowledge it is currently a unique approach for a power contrast for less than 20 db.

A further advantage of the present invention is that the filter implementation does not require additional efforts concerning memory or computation and it can be easily integrated into existing solutions.

Yet another advantage of the present invention is that the method according to the inventions provided filters that enable that further information could be encoded in frequency domains. Thus the efficiency of telecommunication devices (bandwidth, band usage etc.) is further increased.

These and many other objects and advantages of the present invention will become apparent to those of ordinary skill in the art from a consideration of the drawings and ensuing description.

**Figure. 1** is a schematic drawing of signal transformation according to prior art.

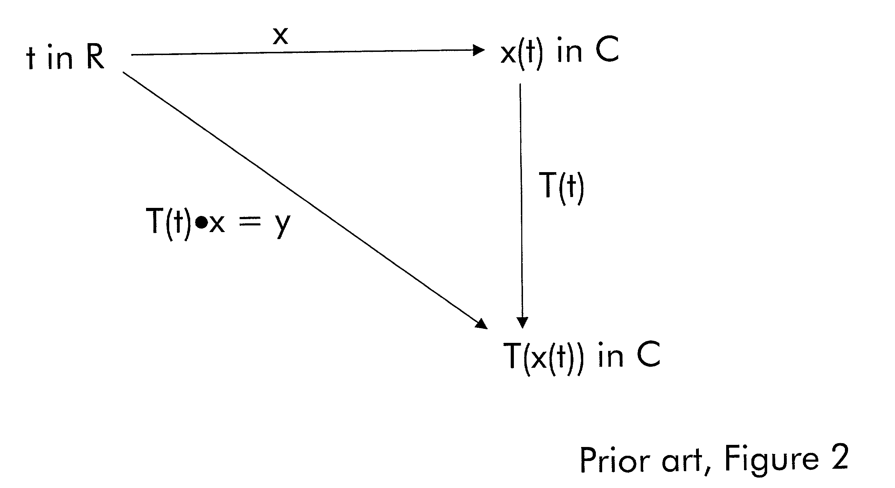

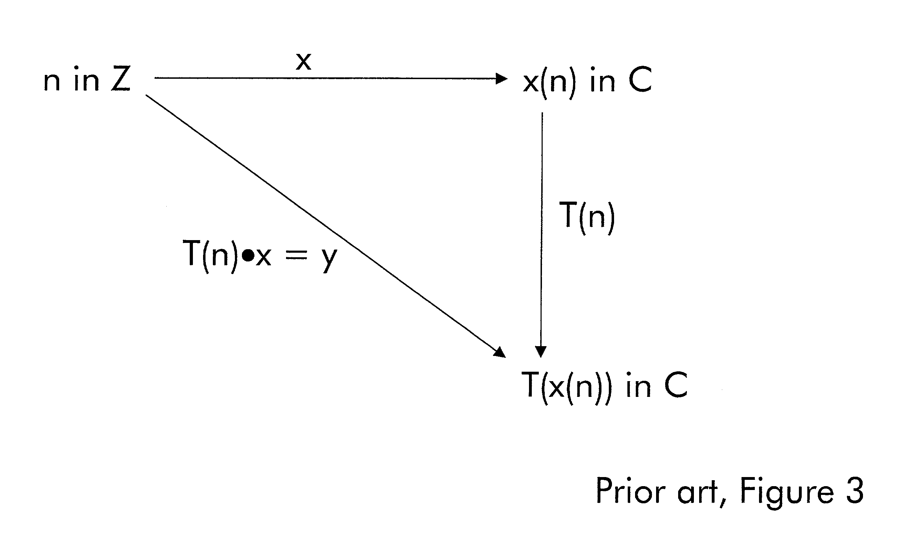

**Figure. 2 and 3** are commuting diagrams showing the connections between an input signal, an output signal, and a signal transformation.

**Figure. 4** is an principal equation showing the connection between input signal, output signal, and a transfer function.

**Figure. 5** contains two equivalent convolution equations and a system diagram according to prior art.

**Figure. 6** shows several transformations from time into frequency domain according to prior art.

**Figure. 7** shows the two central equations of the calculus of variations.

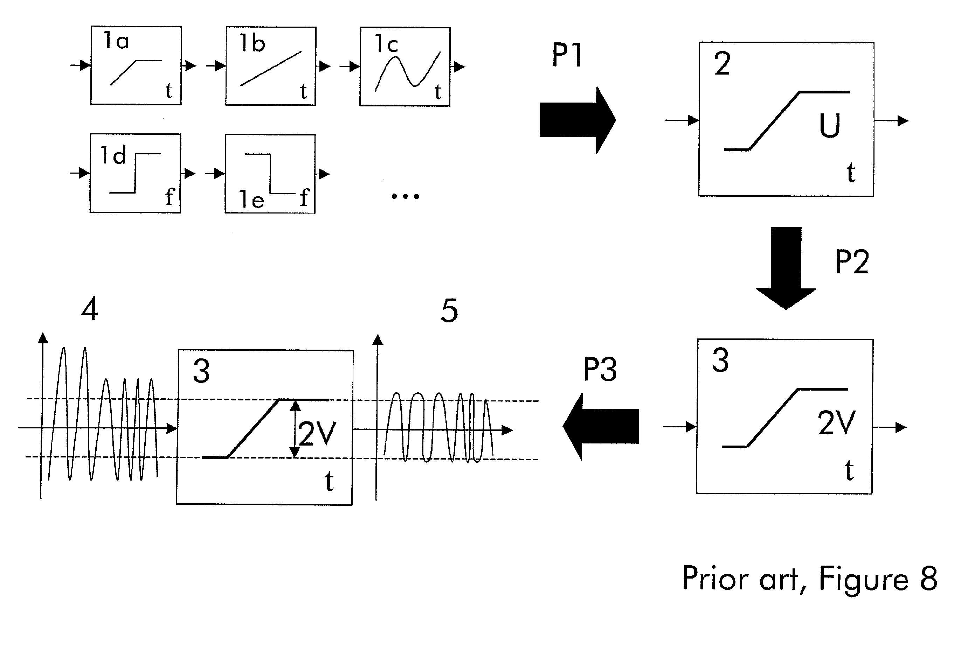

**Figure. 8** illustrates the creation process for a filter according to prior art.

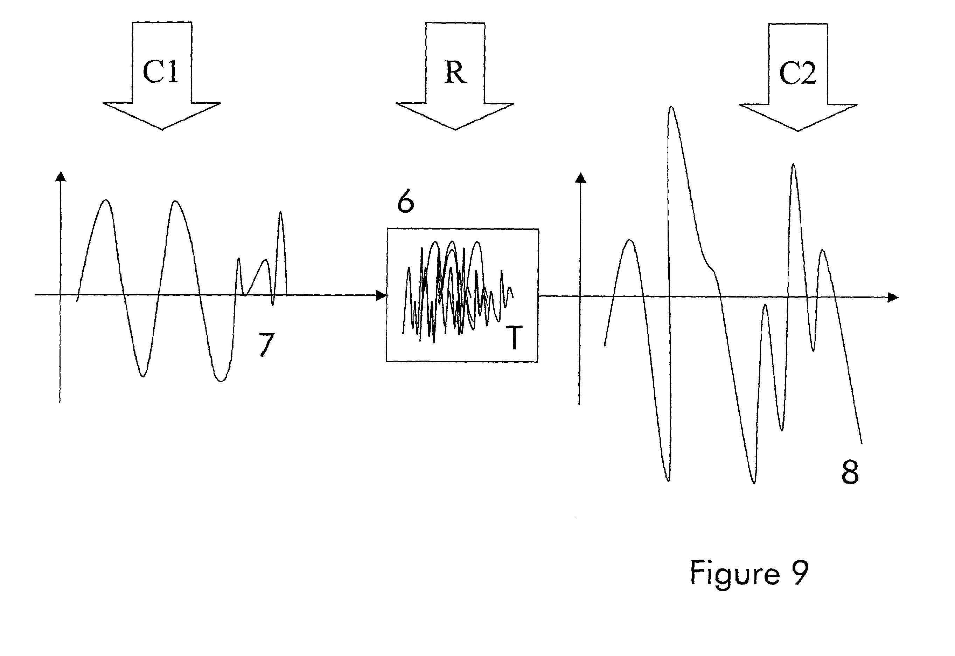

**Figure. 9** illustrates a filters according to the invention.

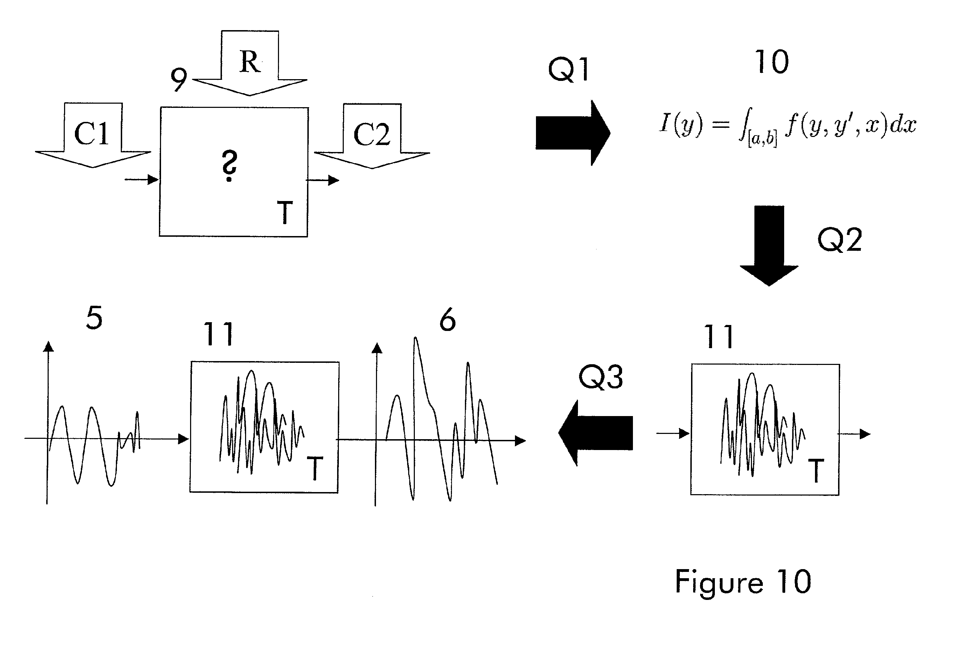

**Figure. 10** illustrates the creation process for a filter according to the invention.

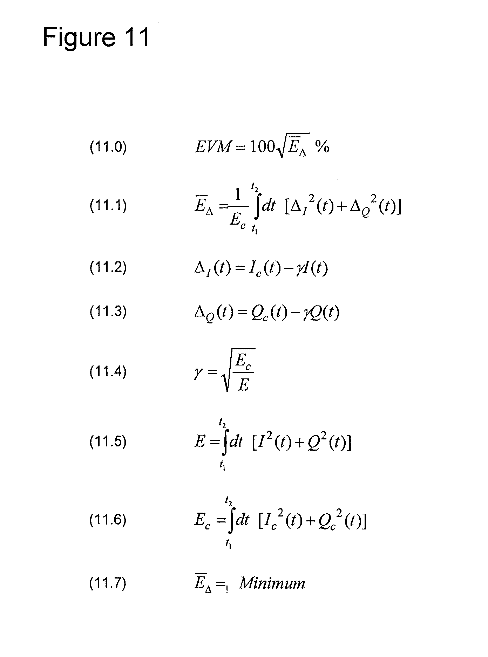

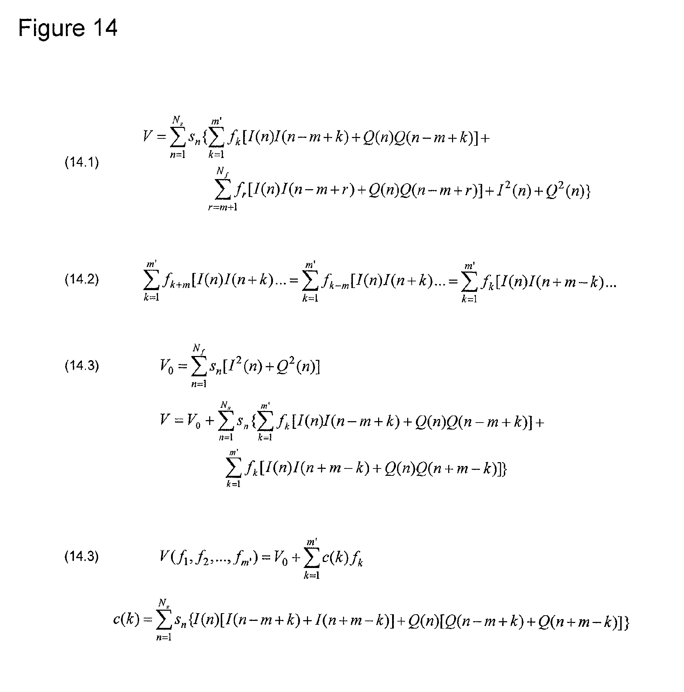

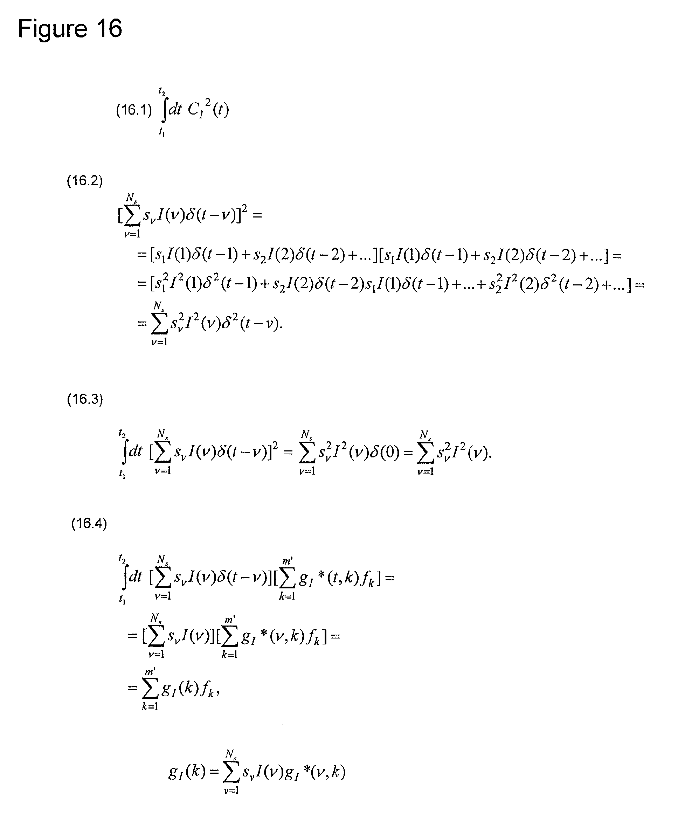

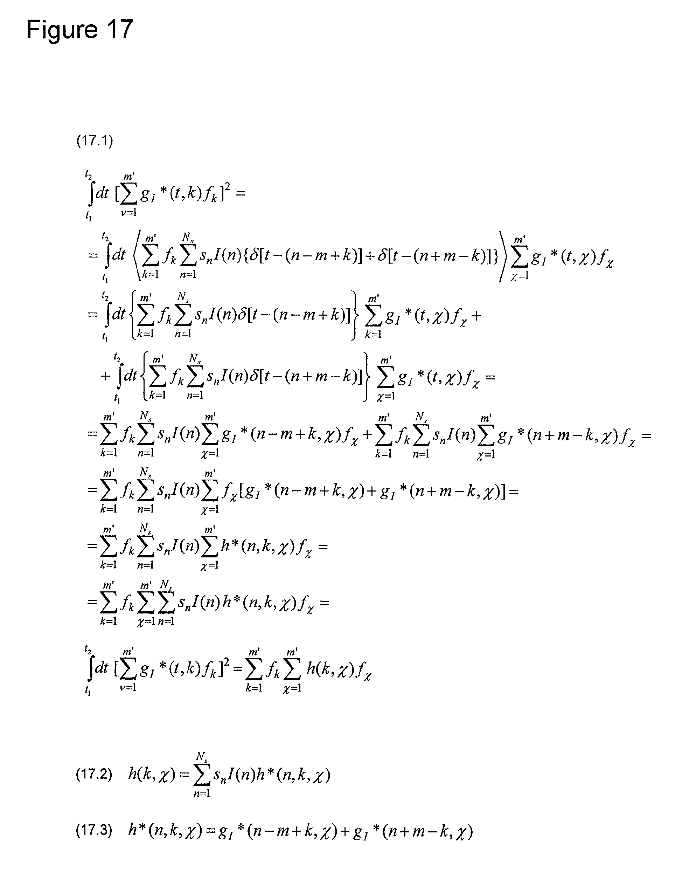

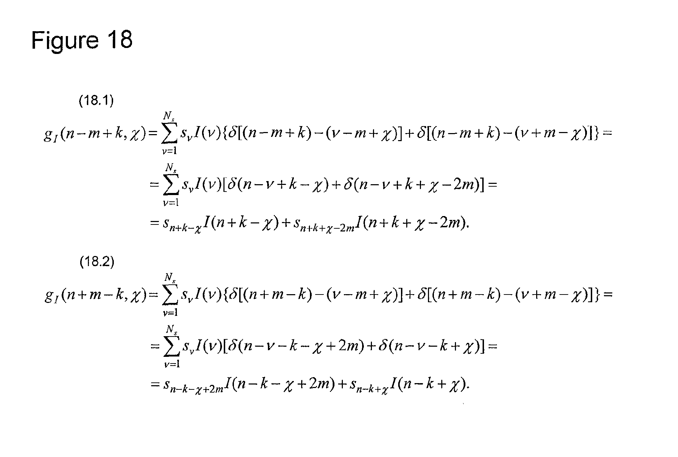

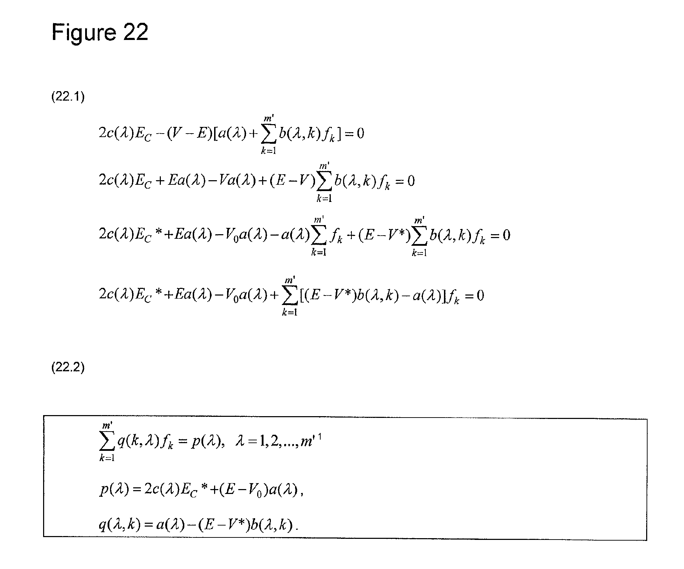

**Figure. 11 to 23** illustrates a sample calculation of a filter according to the invention.

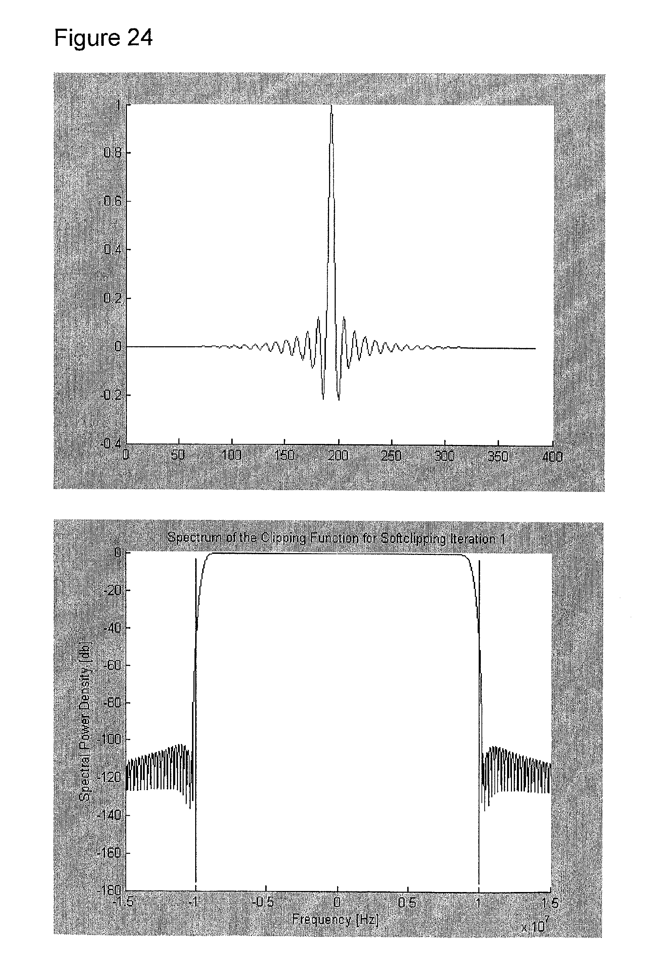

**Figure. 24 to 29** illustrates sample clipping filters in comparison with a clipping filter according to the invention.

Figure 8 shows a set predefined base filters: a clipping filter 1a, an amplifier 1b, an polynomial distorter 1c, a high pass 1d, and a low pass 1 e. In a first phase P1 a base filter is chosen, a clipping filter 2 with parameter U. In the second phase the parameter is determined to 2 Volt which determined the resulting filter 3. In the next phase the filter 3 is tested with an input signals 5, that are transformed into an output signal 6, in order to verify its functionality.

The figure illustrates a prior art process for providing a filter, comprising the steps of choosing a base filter out of a set of basic filter, shown as the first phase P1, parametrizing the base filter, shown in the second phase P2, optionally combining several filters (not shown), and verifying the filter functionality, shown as a third phase P3.

In order to provide a suitable filter the following engineering principle is applied: "parameterize and combined basic filters", like building blocks of a construction kit.

Figure 9 illustrates a filter according to the invention. The filter 6 is specified by e.g. the transformation or the transfer function T. The filters transforms an input signal 7 into an output signal 8. The input signal 7 usually has certain constraints C1. Likewise, the output signal 8 has certain constraints C2. And the filter 6 has to mediate between these constraints C1 and C2 according to filter requirements R.

Figure 10 illustrates the method according to the invention. The figure shows three process steps Q1, Q2, and Q3. The first phase Q1 starts from an filter 9 with unspecified transformation T, shows by the question park. The filter has to fulfill certain requirements R and the input and output signals have certain constraints C1 and C2, respectively. These constraints C1 and C2 and the requirements are translated into a variational problem with constraints, illustrated by the equation 10. The variational problem is solved using e.g. numerical methods or algebraic transformations etc. in a second phase Q2. The solution of the variational problem (either a formula or a numerical solution) determines the / a transformation T. In a third phase Q3 the filter is realized using e.g. a program for a computer or a signal processor, or simply value tables for the transformation(s). The result is a suitable filter 11 that transforms an input signal 5 with constraints C1 to an output signal 6 with constrains C2 according to filter requirements R.

In the following the method according to the invention for realizing a filter is illustrated for clipping in a special application telecommunication context, e.g. high speed down link packet access HSDPA, i.e. transmitting digital multi-carrier signals. Another context might be the transmission of digital multi-carrier signals using, e.g., Orthogonal Code Division Multiplex (OCDM), or Orthogonal Frequency Division Multiplex (OFDM), where the constraint of the filter is not to infringe the orthogonality constraint.

Clipping of digital multi-carrier signals is e.g. necessary in order to reduce the peak to average power ratio for improving the efficiency of a power amplifier without corrupting the wanted signal. By increasing the number of signal carriers, the probability of distortion of single carriers by clipping increases and becomes functionally relevant.

The well known hard-clipping technique consists in cutting signal components higher than a predefined threshold; the soft-clipping technique additionally ensures that no out-of-band interference appears and that the in-band interference is reduced, but the resulting signal is not well clipped. Iterative clipping procedures distort the signal.

In practice, it seems to be enough to handle power contrasts between carriers which are less than about 20db. With this restriction the disadvantages of the prior art approaches can be avoided by using a filter with a transfer function in which those frequency domains are mainly occupied that represent the gaps between the carrier channels, or that are located at the borders of the band. Thus the distortion for each carrier is minimized and carriers having a lower power density level are less distorted. The ideal transfer function has the disadvantage that its impulse response function is quite inapplicable for clipping.

The solution is to define a filter such that

- the impulse response of the filter falls within two predefined envelopes (bounding constraint) and the
- the transfer function of the filter is similar to the ideal transfer function (variational problem)

In order to ensure that clipping does not cause any out-of-band interference, the clipping signal is calculated in such a way that it has approximately the same bandwidth as the transmitted signal. Filters used for those approaches have usually an impulse response function derived from a sinc function. The disadvantage of these filters is that their transfer functions are of a rectangular-like form which fill in nearly the complete frequency domain of the band. Thus, the "energy" produced by the clipping function is spread all over the frequency domain of the band causing distortions of the multi-carrier channels. Especially in case of different channel powers this interference leads to a clear degradation of the soft-clipping performance.

A method is well known which handles the in-band interference in the presence of an unlimited power contrast, more precisely: a power contrast of more than 20db. The method is based on a matched filter with the same or similar mask as the total transmit signal. This forces the subtracted signal to have less power density where carriers have lower power so that distortions done by the clipping signal are distributed uniformly on the carriers. The disadvantages of this method are: an increased computational effort (complex instead of real filter coefficients), more memory (bank of filter coefficients), timing and tuning efforts; and the method does not improve the performance when all carrier work on the same power level.

The clipping filter might be characterized by the impulse response function

$$R(t) = g(t) + f(t),$$

where g(t) is the impulse response function of a predefined ideal filter, and where f(t) is a correction function. There exists a measure function

$$m[x, F(x), F'(x), F''(x), ... ],$$

where x is the frequency, F is the Fourier transformation of f, F' is the first derivation of F with respect to x, F" is the second derivation of F with respect to x, etc.

The filter might be characterized by the criterion that

$$\int_{b}^{a} dx\, m[x, F(x), F'(x), F''(x), ... ]$$

is a minimum. The filter might be further characterized by the constraints

$$e1(t) \leq R(t) \leq e2(t),$$

where e1 (t) and e2(t) are two envelopes. These envelopes might be determined either empirically from the forms of the signals to be clipped, or they are predefined from predefined clipping requirements.

In the case of e.g. a quadrature amplitude modulation which is a method of combining two amplitude-modulated signals into a single channel, thereby doubling the effective bandwidth, the signal has to remain decodable, i.e. the two signals should be recoverable from the filtered signal. The two modulated carriers are combined at the source for transmission. At the destination, the carriers are separated, the data is extracted from each, and then the data is combined into the original modulating information.

In a quadrature amplitude modulation signal, there are two carriers, each having the same frequency but differing in phase. Mathematically, one of the signals can be represented by a sine wave, and the other by a cosine wave, in common by a complex Euler function.

The recoverable property is mathematically formulated by the constraint of orthogonality.

Although illustrative described the method for determining a filter is applied for clipping with band leakage requirements, many variations and modifications are possible which remain within the concept, scope, and spirit of the invention, and these variations would become clear to those of skill in the art after perusal of this application.

In order to illustrate the invention and its application the mathematical background of an filter generation of an optimized error vector magnitude is presented.

Error Vector Magnitude (EVM) involves given reference signals I(t) and Q(t), and Signals under study (clipped reference signal) $I_c(t)$ and $Q_c(t)$.

The Error Vector Magnitude (EVM) is defined in figure 11 where the base identity (11.0) involves several sub equations (11.1) to (11.6). EVM shall be a minimum. If EVM is a minimum, then also $\bar{E}_\Delta$ will be a minimum. Thus the problem is to solve equation (11.7), which is a zero order variational problem.

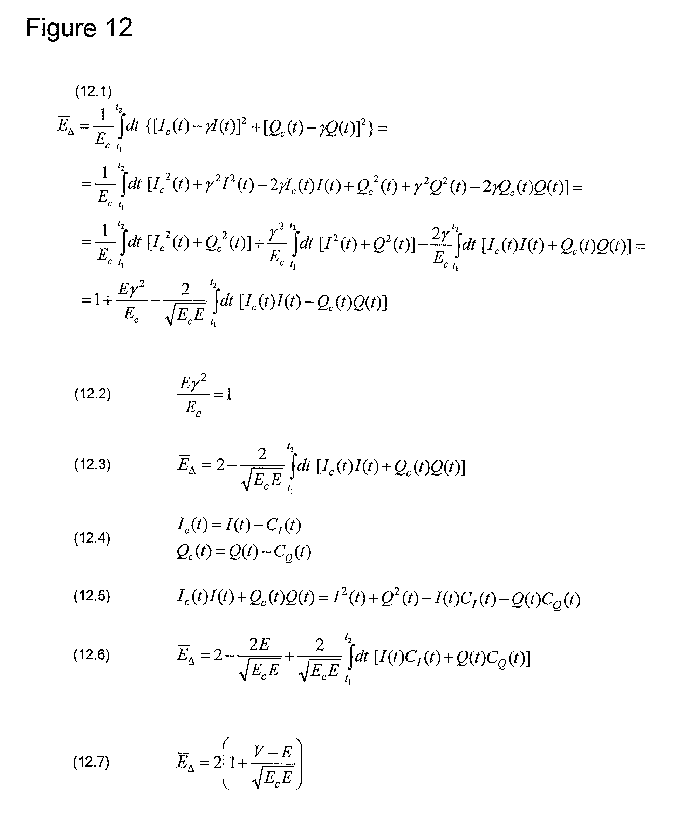

Error Vector Magnitude is in figure 12 equation (12.1) expressed as a function of filter coefficients From the equations in figure 11 it follows that (12.1). Since equation (12.2) it follows further (12.3).

Clipping means that from the original signal a clipping signal $C_I(t)$, respectively $C_Q(t)$ is subtracted having the same spectral characteristics as the original signal. This fact is expressed by equation (12.4) so that (12.5) is valid.

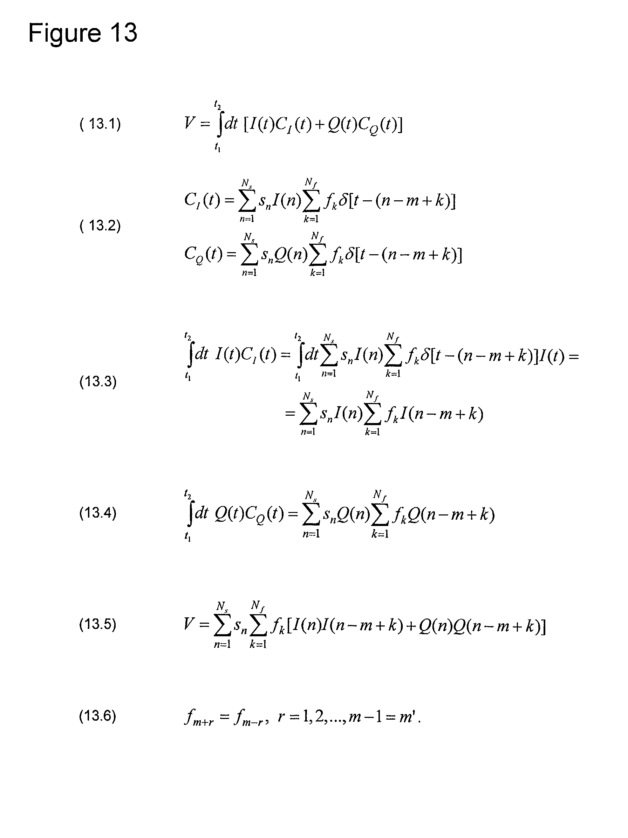

Inserting it into equation (12.3) and by observing equation (11.5) results in (12.6) or (12.7) where V is defined in figure 13, equation (13.1).

To the clipping signals are calculated using the discrete approach in (13.2) and (13.4),

where:

> t varies from 1 to $N_s$, $N_s$ is the number of samples,
> > $S_n$: are scaling factors,
> > $f_k$: clipping filter coefficients,
> k varies from 1 to $N_f$, $N_f$ is the number of filter coefficients (assumed to be odd)
> > $\delta$ is the DIRAC delta function, and
> > m = $(N_f + 1)/2$ is the center of the filter.

Thus V could be expressed as in (13.5). The filter coefficients are symmetrical around the center m and $f_m$ = 1 shown in (13.6). From this it follows (14.1). By substituting r - m = k and by the symmetrically filter coefficients the sum about r is like sown in (14.2), where in the last term the order of summation was changed. In (14.3) V is further divided yielding $V = V(f_1, f_2,..., f_m,)$ dependent on the filter coefficients.

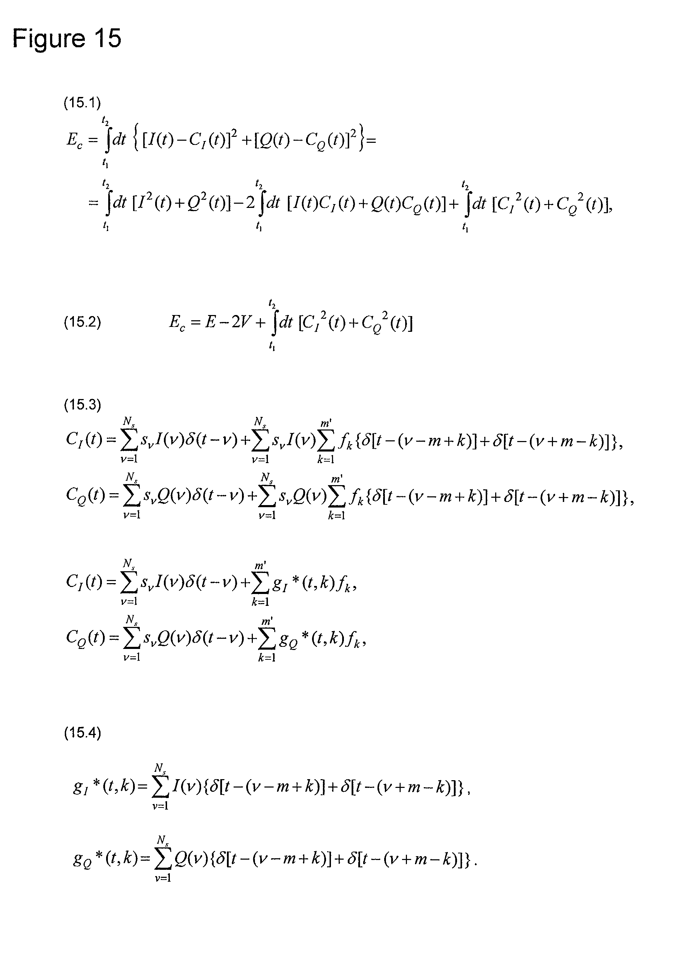

$E_c$ is the other quantity which depends on the filter coefficients. From the definitions of E and V it follows (15.1) shown in figure 15 as well as (15.2).

Observing the symmetry property of the filter coefficients it follows (15.3) where the convolutions are defined ion (15.4).

In the next steps the calculation of the integral of $C_I{}^2$ in (16.1) is prepared. The first term from $C_I{}^2$ is expressed in (16.2).

The integration of this term yields (16.3). The second term from $C_I{}^2$ yields (16.4).

The third term from $C_I{}^2$ is identified in (17.1), with (17.2), (17.3), and introducing further (18.1) and (18.2).

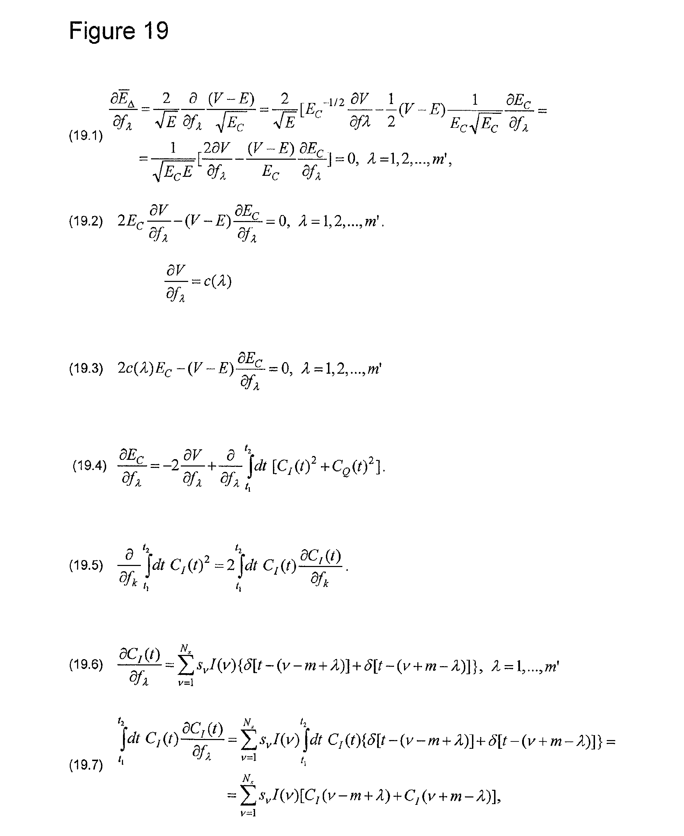

The solution of the minimum condition is shown by the figures 19 to 22. In order to solve the optimization condition one need the first partial derivatives with respect to time. From the equations in figure 11 one gets (19.1) and (19.2).

It follows that $\frac{\partial V}{\partial f_\lambda} = c(\lambda)$ is a constant so that the condition (19.3) has to be fulfilled. The derivative of $E_c$ with respect to $f_\lambda$ is expressed in (19.4) and first

$$\frac{\partial}{\partial f_k} \int_{t_1}^{t_2} dt\ C_I(t)^2$$

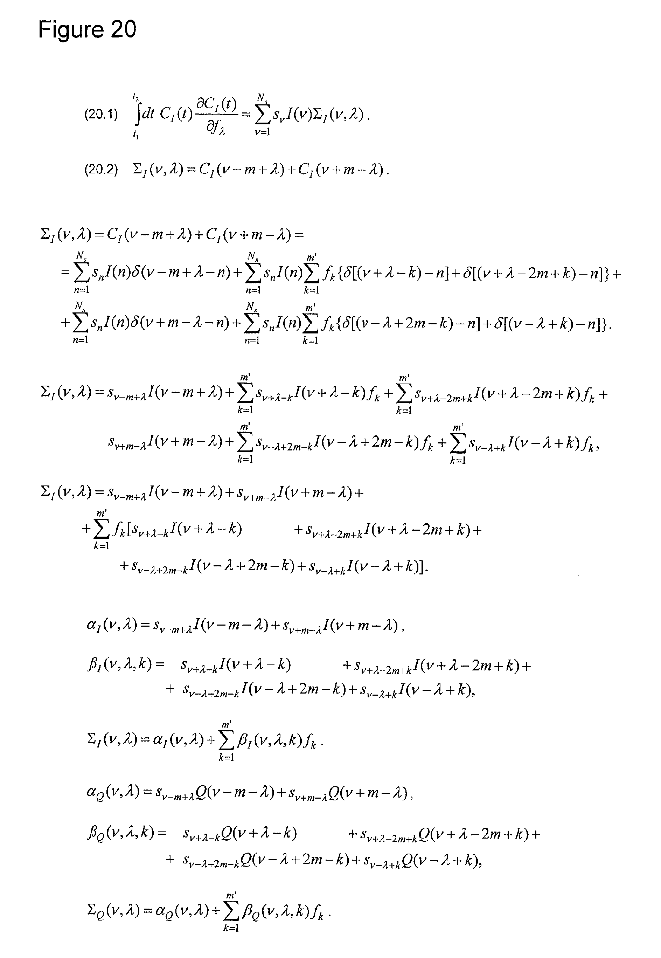

is developed in (19.5), (19.6) and in further in figure 20 applying the DIRAC function, the convolution identities and the equations in figure 11.

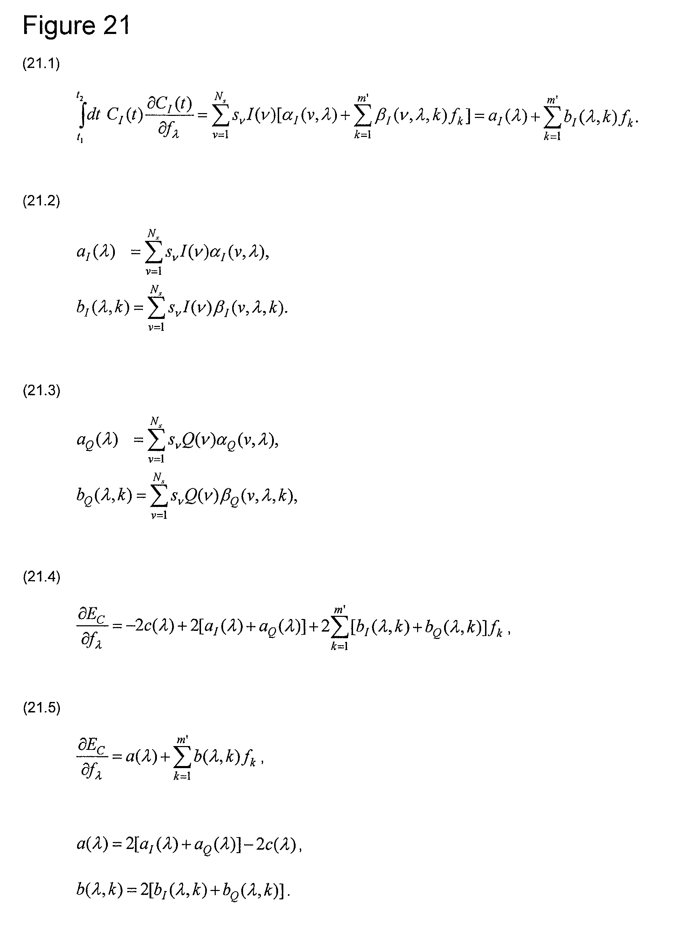

Inserting the results back yields (21.1) in figure 21, where the I and Q sub terms are expressed in (21.2) and (21.3), so that (21.4) is valid ( or equivalently (21.5)).

Returning to the optimization condition and inserting the equations (13.2) results in condition (22.1).

In this equation, $E_c$, V and, of course $f_k$ depend on the filter coefficients. In order to avoid terms quadratic and higher in the filter coefficients, an iteration is applied: $E_c$ and V in the right term are considered to be known from the preceding iteration step; we mark them with an asterisk: '*' indicates the use of the filter coefficients from iteration j, whereas terms without an asterisk belong to the filter coefficients from iteration j+1. Thus the system shown in (21.5) has to be solved.

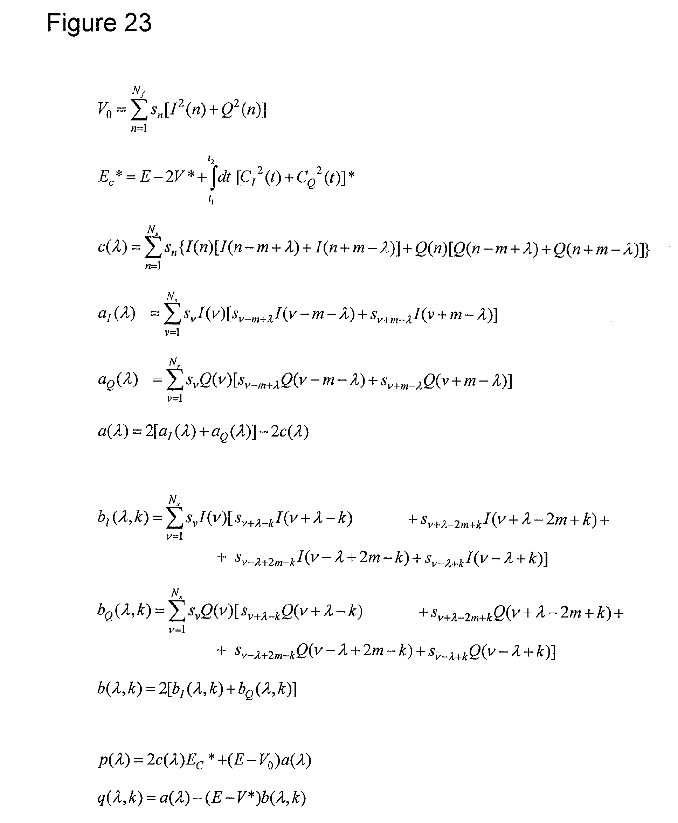

Figure 23 resumes the intermediate results of the calculation. Instead of an discrete approach one could obviously follow an continuous approach replacing the coefficients by functions in a straight forward way.

The above calculation illustrated one example filter calculation whereas the figures 24 till 29 illustrate filter functions of several clipping filters that are numerically derived.

Figure 24 shows a transfer function and the corresponding impulse response function of a real clipping filter. The transfer function is the rectangular like below and the impulse response function is the sinic like.

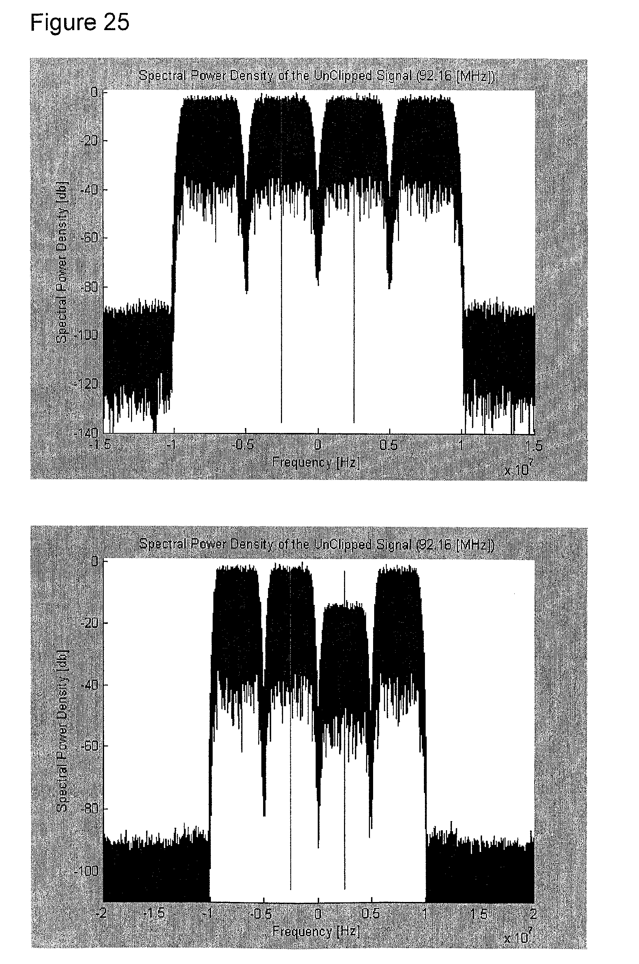

When this filter is confronted with a (four carrier) signal having a spectral power density shown in figure 25 above, all carriers are distorted by the clipping filter defined by the functions shown in figure 25. Below the spectral power density of the distorted (clipped) signal is shown, where especially the third carrier is distorted.

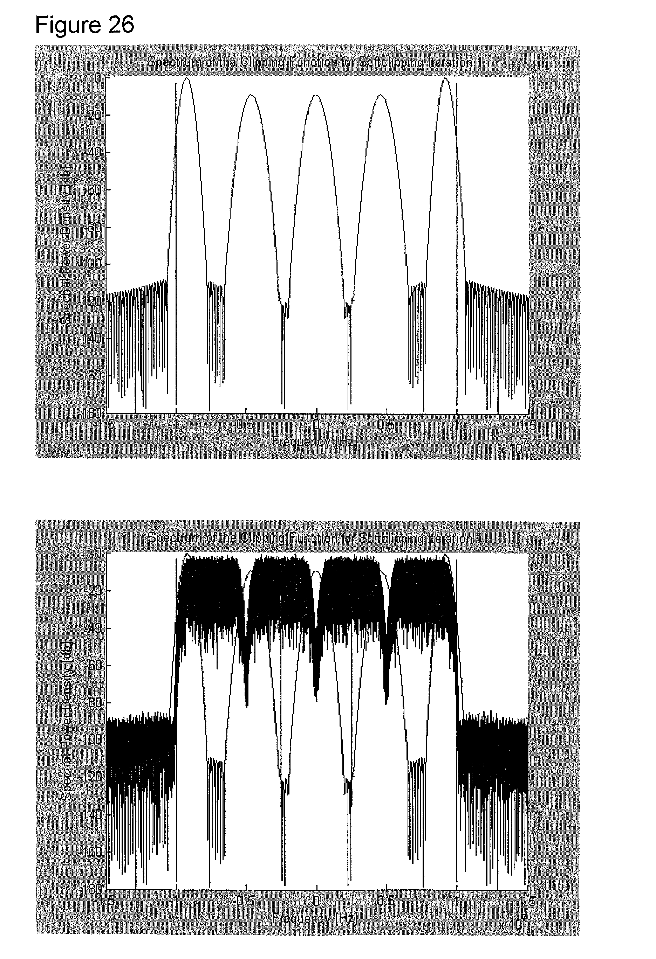

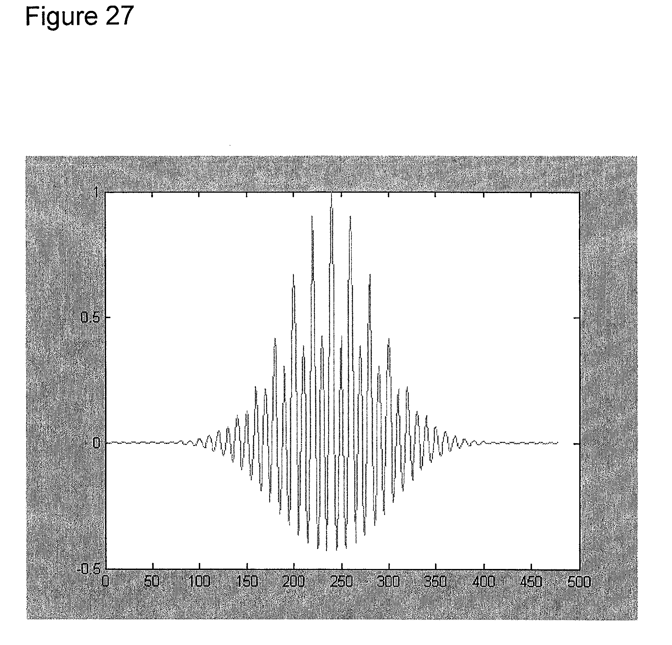

In figure 26 the spectrum of a soft-clipping filter (ideal transfer function with respect to clipping) is shown in the upper part. In the lower part the spectral power density from the signal is overlaid to illustrate that the "energies" are de-coupled. Figure 27 shows the not so advantageous response function of the soft-clopping filter, i.e. from the ideal transfer function.

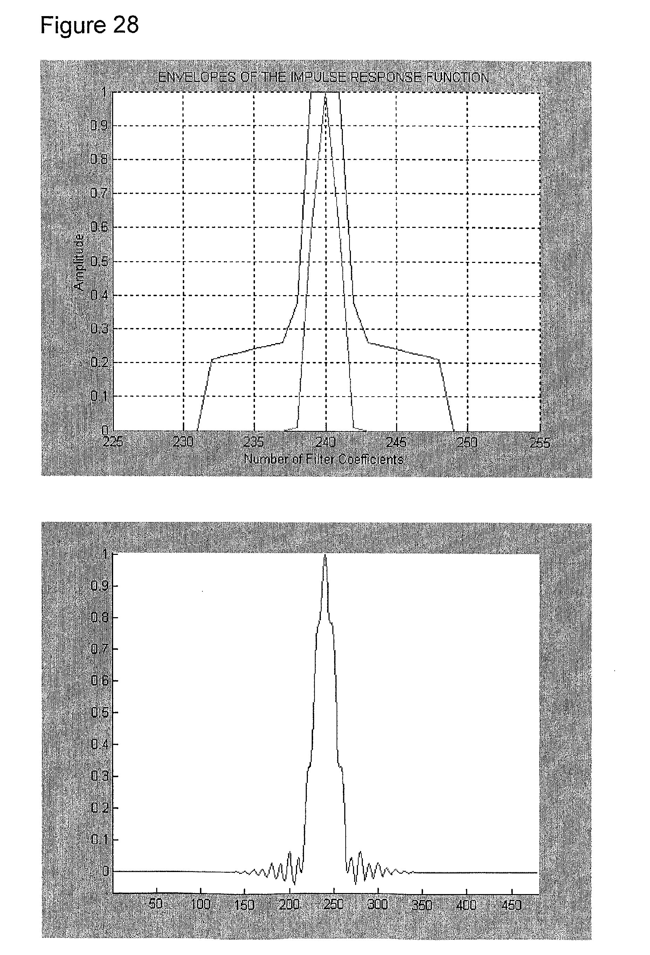

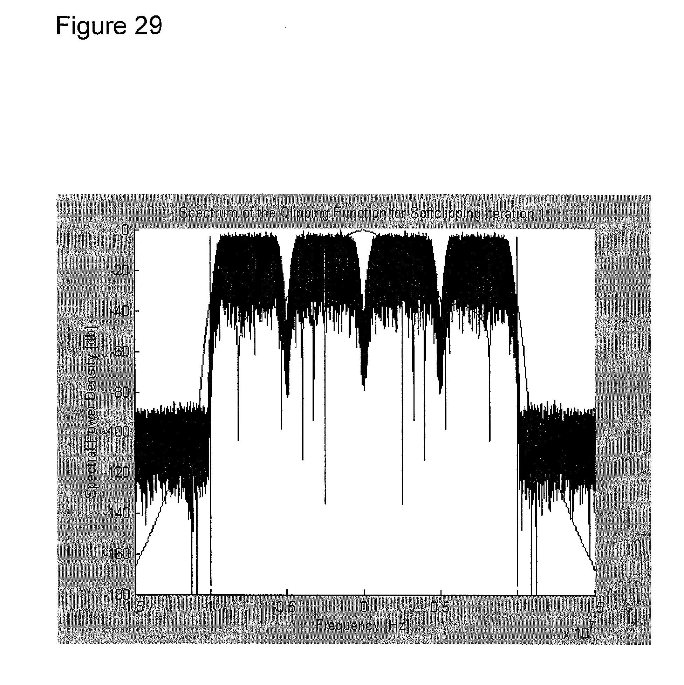

Figure 28 shows in the upper part the two envelopes limiting the variation of the impulse response function. In the lower part a numerically developed (with the method according to the invention) impulse response function is shown. The spectrum of this response function overlaid with the signal is shown in figure 29, also illustrating the de-coupling and was used to derive a clipping filter with minimal out of band interference.

**Claims**

1. A method for providing a filter comprising the steps of

   - determining a set of filter requirements (R) and a set of signal constraints (C1, C2),

   - determining a suited filter transfer function by choosing a set of suited transfer functions and determining a set of parameters of the set of suited transfer functions, and combining said set of transfer functions to a suited filter transfer function (T(n)),

   - realizing the filter specified by the determined suited filter transfer function (T(n))

   **characterized in that** said set of suited transfer functions is determined by solving a variational problem (Figure 7) that is equivalent to the set of filter requirements (R) and a set of signal constraints (C1, C2).

2. The method according to claim 1, **characterized in that** said variational problem is solved numerically.

3. The method according to claim 1, **characterized in that** the variational problem (Figure 7) for determining a suited transfer function (T(n)) is defined by an impulse response function that is equivalent to the transfer function.

4. The method according to claim 2, **characterized in that** said impulse response function is the sum of an impulse response function of a predefined ideal filter and a correction function.

5. The method according to claim 2, **characterized in that** the variational problem (Figure 7) using a measure function that is variable in the transformation of the impulse response function and the impulse response function derivative.

6. The method according to claim 3, **characterized in that** said correction function is limited by an upper and a lower envelope, that is derived from said constraints.

7. A filter compliant with a set of filter requirements (R) and a set of signal constraints (C1, C2), **characterized in that** the filter is defined by a set of filter transfer functions (T(n)) that is determined by solving a variational problem (Figure 7) that is equivalent to the set of filter requirements (R) and a set of signal constraints (C1, C2).

8. The filter (7) according to claim 7, **characterized in that** said filter is a discrete digital filter.

9. A telecommunication device comprising filter for transforming an input signal into an output signal according to a set of filter requirements (R) and a set of signal constraints (C1, C2), **characterized in that** the filter is defined by a set of filter transfer functions that is determined by solving a variational problem (Figure 7) that is equivalent to the set of filter requirements (R) and a set of signal constraints (C1, C2).

$t$ in R $\xrightarrow{\quad x \quad}$ $x(t)$ in C

$t$ in R $\longrightarrow$ $\Big\downarrow$ $T(t)$

$t$ in R $\xrightarrow{\quad y \quad}$ $y(t)$ in C

Prior art, Figure 1

EP 1 526 641 A1

EP 1 526 641 A1

t in R $\xrightarrow{\quad x \quad}$ x(t) in C

T(t)•x = y

T(t)

T(x(t)) in C

Prior art, Figure 2

n in Z $\xrightarrow{\quad x \quad}$ x(n) in C

T(n)•x = y

T(n)

T(x(n)) in C

EP 1 526 641 A1

Prior art, Figure 3

$$
\begin{aligned}
y(n) &= \mathcal{L}_n\{x(\cdot)\} \\
&= \mathcal{L}_n\{(x * \delta)(\cdot)\} \\
&\triangleq \mathcal{L}_n\left\{\sum_{i=-\infty}^{\infty} x(i)\delta(\cdot - i)\right\} \\
&= \sum_{i=-\infty}^{\infty} x(i)\mathcal{L}_n\{\delta(\cdot - i)\} \\
&\triangleq \sum_{i=-\infty}^{\infty} x(i)h(n, i)
\end{aligned}
$$

Prior art, Figure 4

EP 1 526 641 A1

$$y(n) = \sum_{i=0}^{n} x(i)h(n-i) = (x * h)(n)$$

$$y(n) = \sum_{i=0}^{n} h(i)x(n-i) = (h * x)(n)$$

Prior art, Figure 5

EP 1 526 641 A1

Z-transform

$$X_z(n) = \sum_{i=-\infty}^{\infty} x(n)z^{-n}$$

Fourier transform

$$X_f(n) = \sum_{i=-\infty}^{\infty} x(n)e^{-2\pi\iota ni}$$

Laplace transform

$$X_l(n) = \sum_{i=-\infty}^{\infty} x(n)e^{-ni}$$

Prior art, Figure 6

EP 1 526 641 A1

Integral form

$$I(y) = \int_{[a,b]} f(y, y', x)dx$$

Differential form

$$\frac{\partial f}{\partial y} - \frac{d}{dx}\left(\frac{\partial f}{\partial y'}\right) = 0$$

Prior art, Figure 7

EP 1 526 641 A1

Prior art, Figure 8

Figure 9

EP 1 526 641 A1

9

R

C1

?

T

C2

Q1

10

$$I(y) = \int_{[a,b]} f(y, y', x) dx$$

Q2

5

11

T

6

Q3

11

T

Figure 10

# Figure 11

(11.0) $\qquad EVM = 100\sqrt{\overline{E_\Delta}} \ \%$

(11.1) $\qquad \overline{E_\Delta} = \dfrac{1}{E_c} \displaystyle\int_{t_1}^{t_2} dt \ [\Delta_I^2(t) + \Delta_Q^2(t)]$

(11.2) $\qquad \Delta_I(t) = I_c(t) - \gamma I(t)$

(11.3) $\qquad \Delta_Q(t) = Q_c(t) - \gamma Q(t)$

(11.4) $\qquad \gamma = \sqrt{\dfrac{E_c}{E}}$

(11.5) $\qquad E = \displaystyle\int_{t_1}^{t_2} dt \ [I^2(t) + Q^2(t)]$

(11.6) $\qquad E_c = \displaystyle\int_{t_1}^{t_2} dt \ [I_c^2(t) + Q_c^2(t)]$

(11.7) $\qquad \overline{E_\Delta} =_! \ Minimum$

# Figure 12

(12.1)

$$\overline{E}_\Delta = \frac{1}{E_c} \int_{t_1}^{t_2} dt \ \{[I_c(t) - \gamma I(t)]^2 + [Q_c(t) - \gamma Q(t)]^2\} =$$

$$= \frac{1}{E_c} \int_{t_1}^{t_2} dt \ [I_c^2(t) + \gamma^2 I^2(t) - 2\gamma I_c(t)I(t) + Q_c^2(t) + \gamma^2 Q^2(t) - 2\gamma Q_c(t)Q(t)] =$$

$$= \frac{1}{E_c} \int_{t_1}^{t_2} dt \ [I_c^2(t) + Q_c^2(t)] + \frac{\gamma^2}{E_c} \int_{t_1}^{t_2} dt \ [I^2(t) + Q^2(t)] - \frac{2\gamma}{E_c} \int_{t_1}^{t_2} dt \ [I_c(t)I(t) + Q_c(t)Q(t)] =$$

$$= 1 + \frac{E\gamma^2}{E_c} - \frac{2}{\sqrt{E_c E}} \int_{t_1}^{t_2} dt \ [I_c(t)I(t) + Q_c(t)Q(t)]$$

(12.2)

$$\frac{E\gamma^2}{E_c} = 1$$

(12.3)

$$\overline{E}_\Delta = 2 - \frac{2}{\sqrt{E_c E}} \int_{t_1}^{t_2} dt \ [I_c(t)I(t) + Q_c(t)Q(t)]$$

(12.4)

$$I_c(t) = I(t) - C_I(t)$$
$$Q_c(t) = Q(t) - C_Q(t)$$

(12.5)

$$I_c(t)I(t) + Q_c(t)Q(t) = I^2(t) + Q^2(t) - I(t)C_I(t) - Q(t)C_Q(t)$$

(12.6)

$$\overline{E}_\Delta = 2 - \frac{2E}{\sqrt{E_c E}} + \frac{2}{\sqrt{E_c E}} \int_{t_1}^{t_2} dt \ [I(t)C_I(t) + Q(t)C_Q(t)]$$

(12.7)

$$\overline{E}_\Delta = 2 \left(1 + \frac{V - E}{\sqrt{E_c E}}\right)$$

# Figure 13

( 13.1)
$$V = \int_{t_1}^{t_2} dt \ [I(t)C_I(t) + Q(t)C_Q(t)]$$

( 13.2)
$$C_I(t) = \sum_{n=1}^{N_s} s_n I(n) \sum_{k=1}^{N_f} f_k \delta[t - (n - m + k)]$$

$$C_Q(t) = \sum_{n=1}^{N_s} s_n Q(n) \sum_{k=1}^{N_f} f_k \delta[t - (n - m + k)]$$

(13.3)
$$\int_{t_1}^{t_2} dt \ I(t)C_I(t) = \int_{t_1}^{t_2} dt \sum_{n=1}^{N_s} s_n I(n) \sum_{k=1}^{N_f} f_k \delta[t - (n - m + k)]I(t) =$$

$$= \sum_{n=1}^{N_s} s_n I(n) \sum_{k=1}^{N_f} f_k I(n - m + k)$$

(13.4)
$$\int_{t_1}^{t_2} dt \ Q(t)C_Q(t) = \sum_{n=1}^{N_s} s_n Q(n) \sum_{k=1}^{N_f} f_k Q(n - m + k)$$

(13.5)
$$V = \sum_{n=1}^{N_s} s_n \sum_{k=1}^{N_f} f_k [I(n)I(n - m + k) + Q(n)Q(n - m + k)]$$

(13.6)
$$f_{m+r} = f_{m-r}, \ r = 1, 2, ..., m - 1 = m'.$$

# Figure 14

(14.1)
$$V = \sum_{n=1}^{N_s} s_n \{ \sum_{k=1}^{m'} f_k [I(n)I(n-m+k) + Q(n)Q(n-m+k)] +$$
$$\sum_{r=m+1}^{N_f} f_r [I(n)I(n-m+r) + Q(n)Q(n-m+r)] + I^2(n) + Q^2(n) \}$$

(14.2)
$$\sum_{k=1}^{m'} f_{k+m}[I(n)I(n+k)]\ldots = \sum_{k=1}^{m'} f_{k-m}[I(n)I(n+k)]\ldots = \sum_{k=1}^{m'} f_k[I(n)I(n+m-k)\ldots$$

(14.3)
$$V_0 = \sum_{n=1}^{N_f} s_n [I^2(n) + Q^2(n)]$$

$$V = V_0 + \sum_{n=1}^{N_s} s_n \{ \sum_{k=1}^{m'} f_k [I(n)I(n-m+k) + Q(n)Q(n-m+k)] +$$
$$\sum_{k=1}^{m'} f_k [I(n)I(n+m-k) + Q(n)Q(n+m-k)] \}$$

(14.3)
$$V(f_1, f_2, \ldots, f_{m'}) = V_0 + \sum_{k=1}^{m'} c(k) f_k$$

$$c(k) = \sum_{n=1}^{N_s} s_n \{ I(n)[I(n-m+k) + I(n+m-k)] + Q(n)[Q(n-m+k) + Q(n+m-k)] \}$$

# Figure 15

(15.1)

$$E_c = \int_{t_1}^{t_2} dt \left\{ [I(t) - C_I(t)]^2 + [Q(t) - C_Q(t)]^2 \right\} =$$

$$= \int_{t_1}^{t_2} dt \ [I^2(t) + Q^2(t)] - 2\int_{t_1}^{t_2} dt \ [I(t)C_I(t) + Q(t)C_Q(t)] + \int_{t_1}^{t_2} dt \ [C_I^{\ 2}(t) + C_Q^{\ 2}(t)],$$

(15.2)
$$E_c = E - 2V + \int_{t_1}^{t_2} dt \ [C_I^{\ 2}(t) + C_Q^{\ 2}(t)]$$

(15.3)

$$C_I(t) = \sum_{v=1}^{N_s} s_v I(v)\delta(t-v) + \sum_{v=1}^{N_s} s_v I(v) \sum_{k=1}^{m'} f_k \{\delta[t-(v-m+k)] + \delta[t-(v+m-k)]\},$$

$$C_Q(t) = \sum_{v=1}^{N_s} s_v Q(v)\delta(t-v) + \sum_{v=1}^{N_s} s_v Q(v) \sum_{k=1}^{m'} f_k \{\delta[t-(v-m+k)] + \delta[t-(v+m-k)]\},$$

$$C_I(t) = \sum_{v=1}^{N_s} s_v I(v)\delta(t-v) + \sum_{k=1}^{m'} g_I *(t,k) f_k,$$

$$C_Q(t) = \sum_{v=1}^{N_s} s_v Q(v)\delta(t-v) + \sum_{k=1}^{m'} g_Q *(t,k) f_k,$$

(15.4)

$$g_I *(t,k) = \sum_{v=1}^{N_s} I(v)\{\delta[t-(v-m+k)] + \delta[t-(v+m-k)]\},$$

$$g_Q *(t,k) = \sum_{v=1}^{N_s} Q(v)\{\delta[t-(v-m+k)] + \delta[t-(v+m-k)]\}.$$

# Figure 16

(16.1) $\displaystyle\int_{t_1}^{t_2} dt\, C_I^{\,2}(t)$

(16.2)

$$[\sum_{v=1}^{N_s} s_v I(v)\delta(t-v)]^2 =$$

$$= [s_1 I(1)\delta(t-1) + s_2 I(2)\delta(t-2) + ...][s_1 I(1)\delta(t-1) + s_2 I(2)\delta(t-2) + ...] =$$

$$= [s_1^2 I^2(1)\delta^2(t-1) + s_2 I(2)\delta(t-2)s_1 I(1)\delta(t-1) + ... + s_2^2 I^2(2)\delta^2(t-2) + ...] =$$

$$= \sum_{v=1}^{N_s} s_v^2 I^2(v)\delta^2(t-v).$$

(16.3)

$$\int_{t_1}^{t_2} dt\, [\sum_{v=1}^{N_s} s_v I(v)\delta(t-v)]^2 = \sum_{v=1}^{N_s} s_v^2 I^2(v)\delta(0) = \sum_{v=1}^{N_s} s_v^2 I^2(v).$$

(16.4)

$$\int_{t_1}^{t_2} dt\, [\sum_{v=1}^{N_s} s_v I(v)\delta(t-v)][\sum_{k=1}^{m'} g_I *(t,k) f_k] =$$

$$= [\sum_{v=1}^{N_s} s_v I(v)][\sum_{k=1}^{m'} g_I *(v,k) f_k] =$$

$$= \sum_{k=1}^{m'} g_I(k) f_k,$$

$$g_I(k) = \sum_{v=1}^{N_s} s_v I(v) g_I *(v,k)$$

# Figure 17

(17.1)

$$\int_{t_1}^{t_2} dt \ [\sum_{v=1}^{m'} g_I*(t,k) f_k]^2 =$$

$$= \int_{t_1}^{t_2} dt \ \left\langle \sum_{k=1}^{m'} f_k \sum_{n=1}^{N_s} s_n I(n) \{\delta[t-(n-m+k)]+\delta[t-(n+m-k)]\} \right\rangle \sum_{\chi=1}^{m'} g_I*(t,\chi) f_\chi$$

$$= \int_{t_1}^{t_2} dt \left\{ \sum_{k=1}^{m'} f_k \sum_{n=1}^{N_s} s_n I(n) \delta[t-(n-m+k)] \right\} \sum_{k=1}^{m'} g_I*(t,\chi) f_\chi +$$

$$+ \int_{t_1}^{t_2} dt \left\{ \sum_{k=1}^{m'} f_k \sum_{n=1}^{N_s} s_n I(n) \delta[t-(n+m-k)] \right\} \sum_{\chi=1}^{m'} g_I*(t,\chi) f_\chi =$$

$$= \sum_{k=1}^{m'} f_k \sum_{n=1}^{N_s} s_n I(n) \sum_{\chi=1}^{m'} g_I*(n-m+k,\chi) f_\chi + \sum_{k=1}^{m'} f_k \sum_{n=1}^{N_s} s_n I(n) \sum_{\chi=1}^{m'} g_I*(n+m-k,\chi) f_\chi =$$

$$= \sum_{k=1}^{m'} f_k \sum_{n=1}^{N_s} s_n I(n) \sum_{\chi=1}^{m'} f_\chi [g_I*(n-m+k,\chi)+g_I*(n+m-k,\chi)] =$$

$$= \sum_{k=1}^{m'} f_k \sum_{n=1}^{N_s} s_n I(n) \sum_{\chi=1}^{m'} h*(n,k,\chi) f_\chi =$$

$$= \sum_{k=1}^{m'} f_k \sum_{\chi=1}^{m'} \sum_{n=1}^{N_s} s_n I(n) h*(n,k,\chi) f_\chi =$$

$$\int_{t_1}^{t_2} dt \ [\sum_{v=1}^{m'} g_I*(t,k) f_k]^2 = \sum_{k=1}^{m'} f_k \sum_{\chi=1}^{m'} h(k,\chi) f_\chi$$

(17.2) $\quad h(k,\chi) = \sum_{n=1}^{N_s} s_n I(n) h*(n,k,\chi)$

(17.3) $\quad h*(n,k,\chi) = g_I*(n-m+k,\chi) + g_I*(n+m-k,\chi)$

# Figure 18

(18.1)

$$g_I(n-m+k, \chi) = \sum_{v=1}^{N_s} s_v I(v)\{\delta[(n-m+k)-(v-m+\chi)]+\delta[(n-m+k)-(v+m-\chi)]\} =$$

$$= \sum_{v=1}^{N_s} s_v I(v)[\delta(n-v+k-\chi)+\delta(n-v+k+\chi-2m)] =$$

$$= s_{n+k-\chi} I(n+k-\chi) + s_{n+k+\chi-2m} I(n+k+\chi-2m).$$

(18.2)

$$g_I(n+m-k, \chi) = \sum_{v=1}^{N_s} s_v I(v)\{\delta[(n+m-k)-(v-m+\chi)]+\delta[(n+m-k)-(v+m-\chi)]\} =$$

$$= \sum_{v=1}^{N_s} s_v I(v)[\delta(n-v-k-\chi+2m)+\delta(n-v-k+\chi)] =$$

$$= s_{n-k-\chi+2m} I(n-k-\chi+2m) + s_{n-k+\chi} I(n-k+\chi).$$

# Figure 19

(19.1)
$$\frac{\partial \overline{E}_\Delta}{\partial f_\lambda} = \frac{2}{\sqrt{E}} \frac{\partial}{\partial f_\lambda} \frac{(V-E)}{\sqrt{E_C}} = \frac{2}{\sqrt{E}} [E_C^{-1/2} \frac{\partial V}{\partial f\lambda} - \frac{1}{2}(V-E)\frac{1}{E_C\sqrt{E_C}}\frac{\partial E_C}{\partial f_\lambda} =$$
$$= \frac{1}{\sqrt{E_C E}}[\frac{2\partial V}{\partial f_\lambda} - \frac{(V-E)}{E_C}\frac{\partial E_C}{\partial f_\lambda}] = 0, \ \lambda = 1,2,...,m',$$

(19.2)
$$2E_C\frac{\partial V}{\partial f_\lambda} - (V-E)\frac{\partial E_C}{\partial f_\lambda} = 0, \ \lambda = 1,2,...,m'.$$

$$\frac{\partial V}{\partial f_\lambda} = c(\lambda)$$

(19.3)
$$2c(\lambda)E_C - (V-E)\frac{\partial E_C}{\partial f_\lambda} = 0, \ \lambda = 1,2,...,m'$$

(19.4)
$$\frac{\partial E_C}{\partial f_\lambda} = -2\frac{\partial V}{\partial f_\lambda} + \frac{\partial}{\partial f_\lambda}\int_{t_1}^{t_2} dt \ [C_I(t)^2 + C_Q(t)^2].$$

(19.5)
$$\frac{\partial}{\partial f_k}\int_{t_1}^{t_2} dt \ C_I(t)^2 = 2\int_{t_1}^{t_2} dt \ C_I(t)\frac{\partial C_I(t)}{\partial f_k}.$$

(19.6)
$$\frac{\partial C_I(t)}{\partial f_\lambda} = \sum_{v=1}^{N_s} s_v I(v)\{\delta[t - (v-m+\lambda)] + \delta[t - (v+m-\lambda)]\}, \ \lambda = 1,...,m'$$

(19.7)
$$\int_{t_1}^{t_2} dt \ C_I(t)\frac{\partial C_I(t)}{\partial f_\lambda} = \sum_{v=1}^{N_s} s_v I(v) \int_{t_1}^{t_2} dt \ C_I(t)\{\delta[t - (v-m+\lambda)] + \delta[t - (v+m-\lambda)]\} =$$
$$= \sum_{v=1}^{N_s} s_v I(v)[C_I(v-m+\lambda) + C_I(v+m-\lambda)],$$

# Figure 20

(20.1)  $\displaystyle\int_{t_1}^{t_2} dt\; C_I(t)\frac{\partial C_I(t)}{\partial f_\lambda} = \sum_{\nu=1}^{N_s} s_\nu I(\nu)\Sigma_I(\nu,\lambda)$,

(20.2)  $\Sigma_I(\nu,\lambda) = C_I(\nu - m + \lambda) + C_I(\nu + m - \lambda)$.

$\Sigma_I(\nu,\lambda) = C_I(\nu - m + \lambda) + C_I(\nu + m - \lambda) =$

$\displaystyle = \sum_{n=1}^{N_s} s_n I(n)\delta(\nu - m + \lambda - n) + \sum_{n=1}^{N_s} s_n I(n)\sum_{k=1}^{m'} f_k\{\delta[(\nu + \lambda - k) - n] + \delta[(\nu + \lambda - 2m + k) - n]\} +$

$\displaystyle + \sum_{n=1}^{N_s} s_n I(n)\delta(\nu + m - \lambda - n) + \sum_{n=1}^{N_s} s_n I(n)\sum_{k=1}^{m'} f_k\{\delta[(\nu - \lambda + 2m - k) - n] + \delta[(\nu - \lambda + k) - n]\}.$

$\displaystyle \Sigma_I(\nu,\lambda) = s_{\nu-m+\lambda}I(\nu - m + \lambda) + \sum_{k=1}^{m'} s_{\nu+\lambda-k}I(\nu + \lambda - k)f_k + \sum_{k=1}^{m'} s_{\nu+\lambda-2m+k}I(\nu + \lambda - 2m + k)f_k +$

$\displaystyle s_{\nu+m-\lambda}I(\nu + m - \lambda) + \sum_{k=1}^{m'} s_{\nu-\lambda+2m-k}I(\nu - \lambda + 2m - k)f_k + \sum_{k=1}^{m'} s_{\nu-\lambda+k}I(\nu - \lambda + k)f_k,$

$\Sigma_I(\nu,\lambda) = s_{\nu-m+\lambda}I(\nu - m + \lambda) + s_{\nu+m-\lambda}I(\nu + m - \lambda) +$

$\displaystyle + \sum_{k=1}^{m'} f_k[s_{\nu+\lambda-k}I(\nu + \lambda - k) \qquad + s_{\nu+\lambda-2m+k}I(\nu + \lambda - 2m + k) +$

$\qquad + s_{\nu-\lambda+2m-k}I(\nu - \lambda + 2m - k) + s_{\nu-\lambda+k}I(\nu - \lambda + k)].$

$\alpha_I(\nu,\lambda) = s_{\nu-m+\lambda}I(\nu - m - \lambda) + s_{\nu+m-\lambda}I(\nu + m - \lambda)$,

$\beta_I(\nu,\lambda,k) = \quad s_{\nu+\lambda-k}I(\nu + \lambda - k) \qquad + s_{\nu+\lambda-2m+k}I(\nu + \lambda - 2m + k) +$
$\qquad\qquad + \; s_{\nu-\lambda+2m-k}I(\nu - \lambda + 2m - k) + s_{\nu-\lambda+k}I(\nu - \lambda + k),$

$\displaystyle \Sigma_I(\nu,\lambda) = \alpha_I(\nu,\lambda) + \sum_{k=1}^{m'} \beta_I(\nu,\lambda,k)f_k$.

$\alpha_Q(\nu,\lambda) = s_{\nu-m+\lambda}Q(\nu - m - \lambda) + s_{\nu+m-\lambda}Q(\nu + m - \lambda)$,

$\beta_Q(\nu,\lambda,k) = \quad s_{\nu+\lambda-k}Q(\nu + \lambda - k) \qquad + s_{\nu+\lambda-2m+k}Q(\nu + \lambda - 2m + k) +$
$\qquad\qquad + \; s_{\nu-\lambda+2m-k}Q(\nu - \lambda + 2m - k) + s_{\nu-\lambda+k}Q(\nu - \lambda + k),$

$\displaystyle \Sigma_Q(\nu,\lambda) = \alpha_Q(\nu,\lambda) + \sum_{k=1}^{m'} \beta_Q(\nu,\lambda,k)f_k$.

# Figure 21

(21.1)

$$\int_{t_1}^{t_2} dt\, C_I(t)\frac{\partial C_I(t)}{\partial f_\lambda} = \sum_{\nu=1}^{N_s} s_\nu I(\nu)[\alpha_I(\nu,\lambda) + \sum_{k=1}^{m'} \beta_I(\nu,\lambda,k)f_k] = a_I(\lambda) + \sum_{k=1}^{m'} b_I(\lambda,k)f_k.$$

(21.2)

$$a_I(\lambda) = \sum_{\nu=1}^{N_s} s_\nu I(\nu)\alpha_I(\nu,\lambda),$$

$$b_I(\lambda,k) = \sum_{\nu=1}^{N_s} s_\nu I(\nu)\beta_I(\nu,\lambda,k).$$

(21.3)

$$a_Q(\lambda) = \sum_{\nu=1}^{N_s} s_\nu Q(\nu)\alpha_Q(\nu,\lambda),$$

$$b_Q(\lambda,k) = \sum_{\nu=1}^{N_s} s_\nu Q(\nu)\beta_Q(\nu,\lambda,k),$$

(21.4)

$$\frac{\partial E_C}{\partial f_\lambda} = -2c(\lambda) + 2[a_I(\lambda) + a_Q(\lambda)] + 2\sum_{k=1}^{m'}[b_I(\lambda,k) + b_Q(\lambda,k)]f_k,$$

(21.5)

$$\frac{\partial E_C}{\partial f_\lambda} = a(\lambda) + \sum_{k=1}^{m'} b(\lambda,k)f_k,$$

$$a(\lambda) = 2[a_I(\lambda) + a_Q(\lambda)] - 2c(\lambda),$$

$$b(\lambda,k) = 2[b_I(\lambda,k) + b_Q(\lambda,k)].$$

## Figure 22

(22.1)

$$2c(\lambda)E_C - (V-E)[a(\lambda)+\sum_{k=1}^{m'}b(\lambda,k)f_k]=0$$

$$2c(\lambda)E_C + Ea(\lambda)-Va(\lambda)+(E-V)\sum_{k=1}^{m'}b(\lambda,k)f_k=0$$

$$2c(\lambda)E_C* +Ea(\lambda)-V_0a(\lambda)-a(\lambda)\sum_{k=1}^{m'}f_k+(E-V^*)\sum_{k=1}^{m'}b(\lambda,k)f_k=0$$

$$2c(\lambda)E_C* +Ea(\lambda)-V_0a(\lambda)+\sum_{k=1}^{m'}[(E-V^*)b(\lambda,k)-a(\lambda)]f_k=0$$

(22.2)

$$\sum_{k=1}^{m'}q(k,\lambda)f_k=p(\lambda), \quad \lambda=1,2,...,m'^{1}$$

$$p(\lambda)=2c(\lambda)E_C* +(E-V_0)a(\lambda),$$

$$q(\lambda,k)=a(\lambda)-(E-V^*)b(\lambda,k).$$

# Figure 23

$$V_0 = \sum_{n=1}^{N_f} s_n [I^2(n) + Q^2(n)]$$

$$E_c^* = E - 2V^* + \int_{t_1}^{t_2} dt \ [C_I^{\ 2}(t) + C_Q^{\ 2}(t)]^*$$

$$c(\lambda) = \sum_{n=1}^{N_s} s_n \{I(n)[I(n-m+\lambda) + I(n+m-\lambda)] + Q(n)[Q(n-m+\lambda) + Q(n+m-\lambda)]\}$$

$$a_I(\lambda) \ = \sum_{\nu=1}^{N_s} s_\nu I(\nu)[s_{\nu-m+\lambda} I(\nu-m-\lambda) + s_{\nu+m-\lambda} I(\nu+m-\lambda)]$$

$$a_Q(\lambda) \ = \sum_{\nu=1}^{N_s} s_\nu Q(\nu)[s_{\nu-m+\lambda} Q(\nu-m-\lambda) + s_{\nu+m-\lambda} Q(\nu+m-\lambda)]$$

$$a(\lambda) = 2[a_I(\lambda) + a_Q(\lambda)] - 2c(\lambda)$$

$$b_I(\lambda,k) = \sum_{\nu=1}^{N_s} s_\nu I(\nu)[s_{\nu+\lambda-k} I(\nu+\lambda-k) \qquad + s_{\nu+\lambda-2m+k} I(\nu+\lambda-2m+k) +$$
$$+ \ s_{\nu-\lambda+2m-k} I(\nu-\lambda+2m-k) + s_{\nu-\lambda+k} I(\nu-\lambda+k)]$$

$$b_Q(\lambda,k) = \sum_{\nu=1}^{N_s} s_\nu Q(\nu)[s_{\nu+\lambda-k} Q(\nu+\lambda-k) \qquad + s_{\nu+\lambda-2m+k} Q(\nu+\lambda-2m+k) +$$
$$+ \ s_{\nu-\lambda+2m-k} Q(\nu-\lambda+2m-k) + s_{\nu-\lambda+k} Q(\nu-\lambda+k)]$$

$$b(\lambda,k) = 2[b_I(\lambda,k) + b_Q(\lambda,k)]$$

$$p(\lambda) = 2c(\lambda)E_C^* + (E - V_0)a(\lambda)$$

$$q(\lambda,k) = a(\lambda) - (E - V^*)b(\lambda,k)$$

## Figure 24

## Figure 25

## Figure 26

Spectrum of the Clipping Function for Softclipping Iteration 1

Spectrum of the Clipping Function for Softclipping Iteration 1

Figure 27

## Figure 28

Figure 29

Spectrum of the Clipping Function for Softclipping Iteration 1

**European Patent Office**

## EUROPEAN SEARCH REPORT

Application Number

EP 03 29 2632

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EMMANOUIL Z. PSARAKIS ; GEORGE V. MOUSTAKIDES: "An L2-Based Method for the Design of 1-D Zero Phase FIR Digital Filters" IEEE TRANSACTIONS ON CIRCUITS AND SYSTEMS I: FUNDAMENTAL THEORY AND APPLICATIONS, vol. 44, no. 7, 1 July 1997 (1997-07-01), pages 591-601, XP000731188 New York, U.S.A. * page 592, left-hand column - page 598, right-hand column * * page 599, right-hand column - page 600, left-hand column * | 1,2,7,8 | H03H17/02 |
| Y | | 3,4 | |
| A | | 5,6,9 | |
| X | US 4 644 562 A (SALZ JACK  ET AL) 17 February 1987 (1987-02-17) * column 3, line 61 - column 4, line 11; figure 2 * * column 5, line 7 - column 7, line 62; figures 3,4 * | 7-9 | |
| Y | | 3,4 | TECHNICAL FIELDS SEARCHED (Int.Cl.7) |
| A | | 1,2,5,6 | H03H |
| X | N. V. IVANTSEVICH ; YU. B. MOLCHANOV: "Transfer Function of a Repeater Filter in a Radio Signal Re-Radiation System" RADIO ENGINEERING AND ELECTRONIC PHYSICS, vol. 24, no. 3, March 1979 (1979-03), pages 46-53, XP009027742 U.S.A. * page 46 - page 49 * | 1,7,9 | |
| A | | 2-6,8 | |

-/--

The present search report has been drawn up for all claims

| Place of search | Date of completion of the search | Examiner |
|---|---|---|
| MUNICH | 25 March 2004 | Trafidlo, R |

EPO FORM 1503 03.82 (P04C01)

## EUROPEAN SEARCH REPORT

**European Patent Office**

Application Number

EP 03 29 2632

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | G. CHERUBINI ; S. OLCER ; G. UNGERBOECK: "Optimum Filter Design for Partial-Response Class-IV Transmission Systems" DISCOVERING A NEW WORLD OF COMMUNICATIONS. CHICAGO, JUNE 14 - 18, 1992. BOUND TOGETHER WITH B0190700, VOL. 3, PROCEEDINGS OF THE INTERNATIONAL CONFERENCE ON COMMUNICATIONS, 14 June 1992 (1992-06-14), pages 51-56, XP010061828 New York, U.S.A. * the whole document * | 1,7,9 | |
| A | | 2-6,8 | |
| X | US 5 909 312 A (KONFORTI NAIM ET AL) 1 June 1999 (1999-06-01) * column 4, line 52 - column 8, line 60 * | 1-3,7 | |
| A | | 4-6,8,9 | |
| | | | TECHNICAL FIELDS SEARCHED (Int.Cl.7) |

The present search report has been drawn up for all claims

| Place of search | Date of completion of the search | Examiner |
|---|---|---|
| MUNICH | 25 March 2004 | Trafidlo, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 03 29 2632

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2004

| Patent document cited in search report | | Publication date | Patent family member(s) | | Publication date |
|---|---|---|---|---|---|
| US 4644562 | A | 17-02-1987 | DE<br>EP<br>JP | 3679019 D1<br>0216141 A2<br>62051325 A | 06-06-1991<br>01-04-1987<br>06-03-1987 |
| US 5909312 | A | 01-06-1999 | IL | 119341 A | 22-09-1999 |

For more details about this annex : see Official Journal of the European Patent Office, No. 12/82